# EUROPEAN PATENT SPECIFICATION

(11) **EP 3 657 915 B1**
(45) Date of publication and mention of the grant of the patent: **01.01.2025**
(21) Application number: 19209423.3
(22) Date of filing: 15.11.2019
(51) Int. Cl.: H05K 1/18, H01L 23/538, H01L 21/48, H01L 23/31, H01L 23/498, H01L 21/683, H05K 3/00

(54) **METHOD OF MANUFACTURING A COMPONENT CARRIER USING A SEPARATION COMPONENT AND A SEMI-FINISHED PRODUCT**
VERFAHREN ZUR HERSTELLUNG EINES KOMPONENTENTRÄGERS UNTER VERWENDUNG EINER TRENNKOMPONENTE UND HALBFABRIKAT
PROCÉDÉ DE FABRICATION D'UN SUPPORT DE COMPOSANTS À L'AIDE D'UN COMPOSANT DE SÉPARATION ET PRODUIT SEMI-FINI

(30) Priority: 20.11.2018 CN 201811384918
(43) Date of publication of application: 27.05.2020
(60) Divisional application: 24214278.4
(73) Proprietor: AT&S (Chongqing) Company Limited, Chongqing 401133 (CN); At&S (China) Co., Ltd., Shanghai 201108 (CN)
(72) Inventor: Mok, Jeesoo, Chongqing, Chongqing (CN); Tay, Seok Kim, 128807 Singapore (SG); Tuominen, Mikael, Shanghai, Shanghai 201100 (CN); Wu, Yu-Hui, 328 Taoyuan City (TW)
(74) Representative: Donatello, Daniele

(56) References cited:
- US-A1- 2015 041 053
- US-A1- 2015 223 341

## Description

The invention relates to a method of manufacturing a component carrier, and to a semi-finished product.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions. In particular, efficiently embedding an electronic component into a component carrier and later-on electrically connecting said embedded electronic component remains a challenge.

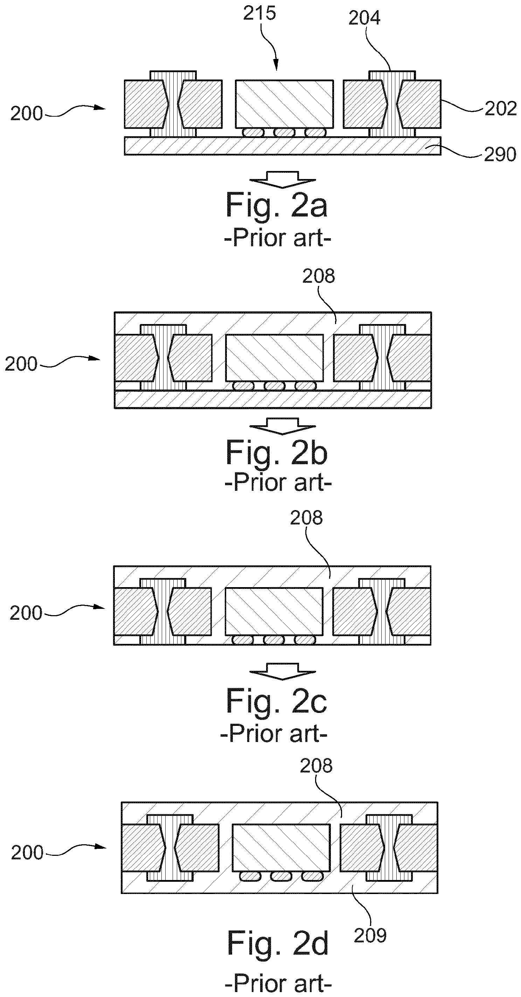

**Figure 2** shows an example from the prior art. A preform of a printed circuit board 200 is provided, comprising electrically conductive layer structures 204 in an electrically insulating core 202 having a cavity 211. Said core 202 is attached to a sticky tape 290 such that a chip 215 can be placed in the cavity onto the sticky tape 290 (Figure 2a). Then, a first lamination step is performed in order to embed the chip 215 (Figure 2b) in an electrically insulating embedding material 208. In the next step, the sticky tape 290 is detached (Figure 2c) and in the last step, a further lamination is done in order to fully embed the chip 215 in further electrically insulating material 209 (Figure 2d).

However, the prior art methods suffer from warpage issues, especially in the case when large dies are embedded. In order to overcome this issue, very thick core structures are used, even though thin core design provide many advantages over thick core structures, e.g. with respect to space requirements and heat dissipation. But in the case of thin core processing there is a high risk of yield drop regarding the process described above. Furthermore, thermal management is problematic due to heat produced by the embedded chip. This is especially true in the thick core structure, wherein it is more difficult to efficiently dissipate the produced heat.

Document US 2015/223341 A1 discloses a method to form a pair of component carriers firstly providing two substrates with a respective cavity and a respective component inserted, followed by the stack of the two substrates on a respective bounding layer each provided on one of two opposite sides of a temporary carrier, so that the spaces between the components and the substrate is filled by said bounding layer flowing into these spaces, followed by the separation of the two resulting component carriers from the temporary carrier.

Document US 2015/223341 A1 discloses an alternative method in which the pair of substrates are firstly attached to two opposed sides of a temporary carrier, followed by the insertion of two components on the respective cavity provided on each substrate, followed by the filling of the spaces between the components and the respective substrate by insulating material, finalizing the method through the detachment of the resulting component carriers from the temporary carrier.

It is an object of the invention to provide a method of manufacturing a component carrier with an embedded component in an efficient and roust manner.

In order to achieve the object defined above, a method of manufacturing a first component carrier and a second component carrier on the one hand and a semi-finished product is on the other hand are provided according to the independent claims.

As a result of the method and the semi-finished product according to the invention, a first and second component carrier may be provided. According to one example the component carrier may comprises: i) a layer stack comprising electrically conductive layer structures and electrically insulating layer structures, wherein at least one electrically insulating layer structure is a low Young modulus layer structure formed of a low Young modulus material (in particular with a Young modulus of less than 10 GPa) and wherein the layer stack is at least partially formed as a redistribution structure, and ii) an electronic component embedded in a cavity of the layer stack and electrically connected with the redistribution structure such that a first electric contact of the electronic component is transferred via the redistribution structure to a second electric contact at a main surface of the layer stack, wherein the second electric contact is larger than the first electric contact. Hereby, the electronic component may be arranged between (in particular directly between) the low Young modulus layer structure and the redistribution structure.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board (PCB), an organic interposer, a substrate-like-PCB (SLP), and an IC (integrated circuit) substrate. A component carrier may also be a hybrid board combining different ones of the above mentioned types of component carriers. In the context of the present application, the component carrier may comprise a layer stack (comprising e.g. at least one electrically insulating layer structure and at least one electrically conductive layer structure) and an electronic component embedded in a cavity of the layer stack. In another embodiment, the component carrier may comprise a base structure connected to an electronic component embedded in a cavity of the base structure. The base structure may be a layer stack or a single layer.

In the context of the present application, the term "base structure" may refer to a preform of a component carrier. For example, the base structure may comprise a layer stack or merely one electrically insulating core structure. Furthermore, the base structure may comprise electrically conductive structures such as vias or layers. Additionally, the base structure comprises a cavity for accommodating an electronic component. The cavity may be formed in a layer stack of the base structure. In another embodiment, the base structure may comprise a hole in a core structure and a temporary carrier may be arranged below the hole. In this manner, a cavity may be formed into which the electronic component could be placed. At a later process stage, e.g. after embedding the electronic component with electrically insulating material, the temporary carrier may be removed. Alternatively, a coreless structure may be used.

In the context of the present application, the difference between a base structure and a component carrier may be seen in that the electronic component, placed into a cavity of the base structure, is connected to said base structure or not. The term "connected" may hereby refer to a physical connection. When the electronic component is merely placed into the cavity, there is not yet a connection present, but a further process step is needed. For example, the electronic component may be embedded in the base structure by further electrically insulating material. In this manner, the electronic component and the base structure would be physically connected. According to a further embodiment, the electronic component may be electrically connected to the base structure, for example by an interconnection via or any other electrically conductive (layer) structure. Also in this manner, there would be a physical connection that goes beyond mere placing. According to a preferred embodiment, the electronic component is at least partially embedded in an additional electrically insulating layer. Said layer may comprise prepreg, i.e. resin material in an uncured state, and may be pressed into the electrically insulating layer in order to be at least partially embedded. Also thereby, the electronic component may be connected to the base structure such that a component carrier is obtained.

In the context of the present application, the term "separation component" may refer to any component that is suitable as a temporary carrier for at least two base structures (i.e. preforms of a component carrier) and also for the component carriers. In a preferred embodiment, the separation component is shaped as a plate with two main surfaces, wherein one main surface is opposed to the other. Each surface may be termed "separation surface" and may be suitable for coupling a base structure. In this manner, on each of the two opposing separation surfaces, one base structure could be coupled. Alternatively, an electrically insulating layer (in a preferred embodiment a prepreg layer with a low Young modulus), may be arranged directly on the separation surfaces and the base structures are then placed onto the electrically insulating layers, respectively. In particular, the base structures may be pressing into the prepreg material. The separation component may be configured such that a feasible detachment of the (semi) finished component carriers is enabled. In an embodiment, the separation component may be configured as a detachment core. An example would be an electrically insulating material that is sandwiched between two copper foils. Hereby, an electrically insulating structure of the component carrier may be easily detachable from the copper foil. The separation component may be a detachment copper foil (DCF).

In the context of the present application, the term "redistribution structure" may refer to an additional structure comprising electrically conductive material (e.g. in the form of a metal layer and/or a conductive via) on an electronic component or a component carrier that makes I/O (inside/outside) pads of an integrated circuit available to other locations. When an electronic component, e.g. an integrated circuit, is manufactured, it usually has a set of I/O pads that are electrically connected (e.g. wire-bonded) to the pins of a package. A redistribution structure may be a structure of wiring on the chip that enables a simpler chip-to-chip, chip-to-component carrier, or component carrier-to-component carrier bonding. In an embodiment, the electric contacts (e.g. pad, terminal) at the component carrier side of the redistribution structure are smaller than the electric contacts at a main surface of the component carrier. The term "redistribution structure" may also include a redistribution layer (PDL) and/or a so-called "fan-out" structure. For example, the redistribution structure may comprise solder balls and/or copper pillars at the side (main surface), which is facing away from the embedded component, in order to be connectable to another, larger, entity. In an exemplary embodiment, the electric contacts of the embedded electronic component may be small in size and a redistribution structure is hence arranged below the electronic component (still within the component carrier). The redistribution structure may hereby be designed such that the small electric contacts of the electronic component are redistributed into terminals of a larger size, e.g. ball-shaped electric contacts (solder balls). In a most basic embodiment, the redistribution structure may be an interconnection via that connects a small electric contact with a larger electric contact. In particular, the small electric contact of an embedded component (in a component carrier) to a larger electric contact at a main surface of the component carrier. In another embodiment, the redistribution structure may comprise two interconnection vias and an electrically conductive layer between the two vias. Hereby, the vias may be arranged such that they are shifted in the horizontal axis with respect to each other. In this manner in can be taken into consideration that the larger electric contact needs more space than the small electric contact. Hence, by applying an electrically conductive layer between the side-shifted vias, the area for arranging the larger electric contacts may be spread.

In the context of the present application, the term "low Young modulus layer structure" may refer to any electrically insulating layer that comprises a Young modulus of less than 10 GPa. The Young modulus may be a mechanical property that measures the stiffness of a solid material. It defines the relationship between stress (force per unit area) and strain (proportional deformation) in a material in the linear elasticity regime of a uniaxial deformation. For example, copper comprises a high Young modulus of 117 GPa, and conventional electrically insulating material of a component carrier, e.g. glass-fiber enforced resin such as FR4, comprises an intermediate Young modulus of around 17 GPa. An example for a low Young modulus layer structure may be a specific prepreg material such as TD002 that comprises a Young modulus that may be much lower than that of FR4, e.g. 7 GPa.

In the context of the present application, the term "arranged in between" may refer to the circumstance that an electronic component is arranged directly in between a low Young modulus layer structure and a redistribution structure as defined above. In other words, the electronic component may be sandwiched between the low Young modulus layer structure and a redistribution structure. In an embodiment, a main surface of the electronic component may be flush with the low Young modulus layer structure. In another preferred embodiment, the electronic component is at least partially embedded in the low Young modulus layer structure. Furthermore, another main surface being opposed to the main surface of the electronic component, may by in direct contact with the redistribution structure. For example, an electric contact of the electronic component may be directly electrically contacted by a part of the redistribution structure, e.g. a via.

The present invention is based on the idea that an electronic component may be embedded in a component carrier in a robust manner with respect to warpage and such that an efficient heat dissipation is achieved, when the component carrier is manufactured using a separation component. Conventionally, an electronic component may be embedded into a component carrier as described with regard to Figure 2 above, using a thick core structure to avoid warpage issues. Besides a slow and un-flexible process flow, the thick core structure makes it especially difficult to efficiently dissipate the heat produced by the embedded electronic component. Another conventional method to deal with the warpage issue is to perform the embedding already at wafer-level. It has now been surprisingly found that an efficient, robust and flexible embedding process may be provided by coupling two preforms of component carrier (base structures) on the two separation surfaces of a separation component, respectively. Even though thin structures without a massive core structure are now used, these are not prone to warpage due to the circumstance that the separation component, sandwiched between the preforms of the component carriers, functions as a stabilization structure during the manufacturing process. In this manner, a symmetrical lamination process may be performed with an efficient improvement regarding warpage. The described method is furthermore advantageous for embedding especially large dies in a medium. Thin preform/base structures may be applied and due to the double (and symmetrical) production on two opposing sides, the process speed may be increased. For example, the whole structure of two component carriers and a separation component may be around 400 µm thick. Thus, the single build-up layers may have a thickness below 70 µm. Therefore, the described method is suitable for being performed at panel-level (hence no wafer-level process needed).

With respect to heat dissipation, this may function much more reliable in a thin component carrier than in a component carrier structure with a thick core structure. Furthermore, with respect to the described possible resulting component carrier, the thermal management may be highly improved by the specific architecture of an embedded electronic component being sandwiched between an electrically insulating layer structure with a low Young modulus and a (electrically conductive) redistribution structure that electrically connects a small electric contact of the embedded component to a large electric contact at the main surface of the component carrier. Thereby, without the need of additional efforts, the redistribution structure (made of an electrically conductive material such as copper) may function as a heat dissipation structure that efficiently guides the heat produced by the embedded component to the exterior of the component carrier (e.g. using an additional heat distribution layer).

In the following, further exemplary embodiments of the method and the component carrier resulting from these exemplary embodiments will be explained.

According to the invention, the method further comprises i) forming, in particular laminating, a first electrically insulating layer on the first separation surface before coupling the first base structure with the first separation surface, and afterwards attaching the first base structure on top of the first electrically insulating layer, and ii) forming, in particular laminating, a second electrically insulating layer on the second separation surface before coupling the second base structure with the second separation surface, and afterwards attaching the second base structure on top of the second electrically insulating layer. This may provide the advantage that the base structures can be attached to the separation component in a flexible and robust manner.

According to the invention, the electrically insulating layers have a larger area size than the separation component. Thereby, also the sidewalls of the separation component may be covered. In this manner, the separation component may be more robust and the electrically insulating layers do not tend to "fall off" anymore. In an embodiment, the electrically insulating layers may be formed of a deformable material so that the base structures may be pressed into it and thereby may be attached to the separation component in an efficient manner.

According to a further exemplary embodiment, the first electrically insulating layer and the second electrically insulating layer comprise or consist of prepreg material. This may provide the advantage that the base structures can be pressed into a deformable material and are thereby efficiently hold in place.

Prepreg material or "pre-impregnated fibers" may be a thermoset polymer matrix material, such as epoxy, or a thermoplastic resin may be already present. The fibers often take the form of a weave and the matrix may be used to bond them together and/or to other components during a manufacturing process. Prepreg may be a printed circuit board material such as FR4 or FR5 in an uncured state. For example, glass fibers may be embedded in an epoxy matrix, however, the material is still uncured or at least not fully cured so that it is deformable to some extent. Being at least partially deformable, it may be possible to press and/or pierce a physical structure into it. For example, an electrically conductive pillar structure of a base structure or an electronic component may be pressed at least partially into the prepreg material. Prepreg may be brought into a cured state by applying high temperature and/or pressure. The cured material may not be deformable anymore.

According to a further exemplary embodiment, the first electrically insulating layer and the second electrically insulating layer are formed of a low Young modulus material with a Young modulus of less than 10 GPa, particulary a Young modulus of less than 2 GPa, more particulary a Young modulus of less than 0,5 GPa. This may provide the advantage that stress is absorbed and crack formation is reduced.

According to a further exemplary embodiment, placing the first electronic component in the first cavity is done after coupling the first base structure with the first separation surface, and placing the second electronic component in the second cavity is done after coupling the second base structure with the second separation surface. This may provide the advantage that the described method is applicable in a flexible manner, while still being robust.

The base structure may comprise an electrically insulating layer structure and electrically conductive structures. These first and second base structures may be placed onto the separation sides of a separation component. Hereby, a respective cavity may be provided in the electrically insulating layer structure, yet without an electronic component. The separation component may comprise electrically insulating layer (e.g. prepreg material) as described above or merely adhesive material layers (e.g. of FR4). The base structures may be pressed into the electrically insulating layers or may be merely adhered to the respective adhesive material layers. Then, the first electronic component may be placed in the first cavity (and adhered to the adhesive material) and the second electronic component may be placed in the second cavity. Afterwards, a lamination step (see description below) may be applied in order to embed the first electronic component and the second electronic component with the electrically insulating material of at least one further electrically insulating layer structure. When the base structures have been adhered to the adhesive material, they may be later-on detached from the separation component in an efficient residue-free manner (optionally using thermal treatment). Optionally further layers of electrically conductive and/or electrically insulating material may be applied before detaching the semi-finished component carriers from the separation component. Finally, a solder mask may be applied to the component carrier/base structure.

According to a further exemplary embodiment, i) placing the first electronic component in the first cavity is done before coupling the first base structure with the first separation surface, and ii) placing the second electronic component in the second cavity is done before coupling the second base structure with the second separation surface. The method further comprising: iii) attaching the first base structure on top of the first electrically insulating layer such that a main surface of the first electronic component is directly attached to the first electrically insulating layer, and iv) attaching the second base structure on top of the second electrically insulating layer such that a main surface of the second electronic component is directly attached to the second electrically insulating layer. This may provide the advantage that the placing of the electronic component can be directly integrated into the production process at the desired position.

In an embodiment, the electronic component may be placed in the cavity, when the base structure is already coupled with the separation component. In a further embodiment, the base structure may be coupled with the separation component and the cavity is still accessible. In this manner, the electronic component may be placed into the base structure while the base structure is already coupled to the separation component. In another embodiment, the electronic component may be placed into the cavity (e.g. on a temporary carrier) and is then already at the base structure, when the base structure is coupled with the separation component. In a preferred embodiment, the base structure and the electronic component (already in the cavity of the base structure) are pressed into a deformable/flexible material on top of the separation component, e.g. an additional electrically insulating layer. In this manner, the base structure and the electronic component can be attached in a robust manner. Hence, the electronic components can be directly integrated into the manufacturing and build-up process.

According to a further exemplary embodiment, the method further comprises: at least partially embedding the first electronic component in the first cavity of the first base structure before attaching the first base structure on top of the first electrically insulating layer (and/or coupling the first base structure with the separation component) and/or at least partially embedding the second electronic component in the second cavity of the second base structure before attaching the second base structure on top of the second electrically insulating layer (and/or coupling the second base structure with the separation component). This may provide the advantage that a robust base structure with an at least partially connected electronic component is attached to the separation component in a stable manner.

The electronic component may be at least partially embedded with an electrically insulating material, e.g. prepreg, or fully embedded before the base structure is coupled to the separation component. The prepreg may be cured after embedding the electronic component or during a later process step. In this manner, the base structure may be more stable and robust and the electronic component may be more stabilized and does not fall off easily. Furthermore, the electronic component may be embedded more efficiently in this manner, than by merely being pressed into a prepreg layer of the separation component. Additionally, the base structure may be pressed into the electrically insulating layer of the separation component such that an un-embedded rest of the base structure/electronic component (not embedded by the electrically insulating material) becomes embedded by pressing the base structure into the (uncured) electrically insulating layer.

According to a further exemplary embodiment, the method further comprising: i) pressing the first electronic component in the first electrically insulating layer so that the first electronic component becomes at least partially embedded by the first electrically insulating layer, and/or ii) pressing the second electronic component in the second electrically insulating layer so that the second electronic component becomes at least partially embedded by the second electrically insulating layer. This may provide the advantage that the electronic component can be fixed and embedded in a fast and efficient manner.

In order to connect the electronic component with the base structure, thereby forming the component carrier, the electronic component may at least partially be embedded with electrically insulating material. Embedding an electronic component may provide many advantages, such as protection against stress or other physical impacts, and a thin structure of the whole component carrier. In the described manner, two tasks may be fulfilled at the same time: i) the electronic component is pressed into the electrically insulating layer (which is at least partially deformable and flexible) and thereby fixed at its position in the cavity of the base structure, and ii) the electronic component is at the same time embedded with the material of the electrically insulating layer. In a preferred embodiment, the electrically insulating layer may hereby be an elastic uncured prepreg material. In a following step, a mixture of high temperature and pressure may be applied in order to cure the prepreg material. This may provide a tight connection between the base structure, the electronic component and the electrically insulating layer.

According to a further exemplary embodiment, the method further comprising: i) laminating a first further electrically insulating layer structure on the first base structure or the first component carrier, in particular such that the first electronic component is at least partially embedded with the first further electrically insulating layer structure, and/or ii) laminating a second further electrically insulating layer structure on the second base structure or the second component carrier, in particular such that the second electronic component is at least partially embedded with the second further electrically insulating layer structure.

According to a further exemplary embodiment, the method further comprising: i) forming a first electrically conductive interconnection, in particular a first via, more in particular through the first further electrically insulating layer structure, in order to electrically contact a first electric contact of the first electronic component, and/or ii) forming a second electrically conductive interconnection, in particular a second via, more in particular through the second further electrically insulating layer structure, in order to electrically contact a first electric contact of the second electronic component. This may provide the advantage that a layer built-up can be performed in an efficient manner using established technologies.

For building-up the layer stack of the component carrier, several layers of electrically insulating material may be laminated on top of the electronic component layer. In order to electrically connect the embedded electronic component, electrically conductive interconnection paths may be established. The material of the further electrically insulating layer structures may hereby be used to at least partially embed the electronic component. In another embodiment, the electronic component is at least partially embedded by material of the electrically insulating layer (described above) and is then further embedded by material of the further electrically insulating layer structure. In an exemplary embodiment, the further electrically insulating layer structure may comprise PID and/or ABF (Ajinomoto build-up film). For layer build-up known technology such as standard HDI (high density integration) SAP (semi-additive process) or mSAP (modified semi-additive process) may be used.

An interconnection path may be an electrically conductive via, at least partially filled with an electrically conductive material such as a metal, e.g. copper. Furthermore, metal like copper comprises a high thermal conductivity such that the heat produced by the electronic component may be directly dissipated through the interconnection path. Besides vias, the interconnection path may also comprise metal layers that electrically (and thermally) connect vias with each other in the horizontal plane.

The term "via" may particularly denote a vertical interconnection access being an electrical connection between layers in a component carrier (e.g. a printed circuit board) that goes through the plane of one or more adjacent layers. The term via may include through-hole vias, buried vias, and blind vias. A blind via may be a via that is not completely drilled through an electrically insulating layer, but is merely formed into the electrically insulating layer. For example, the blind via may extend down to an embedded component. In another context, the term blind via may refer to a via in a component carrier which comprises a plurality of layers, wherein the blind via extends through one or several, but not all, of the plurality of layers of the component carrier. For example, a via may connect an electrically conductive layer on top of an electrically insulating layer, through said electrically insulating layer, to another electrically conductive layer below the electrically insulating layer. There are a variety of techniques available for manufacturing a via and/or a photo via in a component carrier. For example, mechanical drilling or laser drilling using e.g. CO₂ laser, Excimer laser, Nd-YAG laser, UV laser, and a photo via using PID material.

According to a further exemplary embodiment, the method further comprising: i) forming a second electric contact, in particular formed as a solder ball, on a main surface of the first component carrier, and electrically connecting the second electric contact through the first electrically conductive interconnection with the first electric contact of the first electronic component, wherein the second electric contact is larger than the first electric contact of the first electronic component such that a first redistribution structure is provided, and/or ii) forming a further second electric contact, in particular formed as a solder ball, on a further main surface of the second component carrier, and electrically connecting the further second electric contact through the second electrically conductive interconnection with the second electric contact of the second electronic component, wherein the further second electric contact is larger than the further second electric contact of the second electronic component such that a second redistribution structure is provided. This may provide the advantage, that the embedded electronic component can be electrically connected in a very flexible manner. A redistribution structure has already been described above in detail. Such a structure enables an efficient electrical connection between a small electric contact (pad) to a large electric contact (e.g. solder ball).

According to a further exemplary embodiment, the first electronic component is sandwiched between the first electrically insulating layer, in particular at least partially embedded in the first electrically insulating layer, and the first redistribution structure, and/or the second electronic component is sandwiched between the second electrically insulating layer, in particular at least partially embedded in the second electrically insulating layer, and the second redistribution structure. This may provide the advantage that at the same time, i) an efficient redistribution structure is provided, and ii) a component carrier (with an embedded electronic component) is manufactured in a very efficient manner.

The efficient manner of manufacturing the component carrier, by pressing a base structure into an electrically insulating layer, has already been described above. Due to the use of the separation component and two base structures at the same time, a thick structure may be provided such that also coreless structures may be manufactured without warpage problems. This process may further be advantageously combined with the manufacturing of a redistribution structure that efficiently electrically connects the embedded electronic component to the main surface of the component carrier.

According to a further exemplary embodiment, separating comprises: i) detaching the first component carrier including the first electrically insulating layer from the separation component, and/or ii) detaching the second component carrier including the second electrically insulating layer from the separation component. This may provide the advantage, that the component carriers can be detached from the separation component in an efficient manner. At the same time, the electrically insulating layers become advantageously parts of the component carriers.

Electrically insulating material such as resin may not have good adhesive properties with respect to a copper foil that may be on the separation surface of the separation component. Thus, an easy detachment process is achieved.

According to a further exemplary embodiment, attaching the first base structure on top of the first electrically insulating layer further comprises: i) piercing at least one first electrically conductive pillar structure of the first base structure into the first electrically insulating layer, and/or attaching the second base structure on top of the second electrically insulating layer further comprises: ii) piercing at least one second electrically conductive pillar structure of the second base structure into the second electrically insulating layer. This may provide the advantage, that the base structures are attached to the electrically insulating layers in a very robust manner.

Electrically conductive layer structures (e.g. vias) of the base structures may be enlarged in order to form pillar structures. The pillar structures may be long and extend beyond the surface of the base structure. In this manner, when the base structures are placed onto the electrically insulating layers, the pillar structures are pierced into the electrically insulating layers, which are preferably made of a deformable material.

According to a further exemplary embodiment, the separation component is fully surrounded by material of the first electrically insulating layer and the second electrically insulating layer. This may provide the advantage that an undesired detachment of separation component and electrically insulating layer is prevented.

The separation surfaces of the separation component may comprise a metal layer, e.g. a copper foil. The electrically insulating layer may consist of resin, but also other insulating materials are suitable. By completely surrounding the separation component, the electrically insulating layers may be attached to the separation surface in an especially robust manner to prevent undesired detachment from the separation surfaces.

According to a further exemplary embodiment, the separation component is a detachment core, in particular a (electrically insulating) core structure sandwiched between two detach copper foils. This may provide the advantage, that a very cost-efficient and established component can be directly applied. The separation component may be a so-called detachable copper foil (DCF) which may be a mass product that is easily available in large quantities and may even be reused after the manufacturing process.

In a further exemplary embodiment, the separation component may comprise a dummy core sandwiched between two dummy insulator layers which are respectively covered with a copper foil. The dummy core may optionally comprise an electrically conductive structure such as a through-via. The separation surface may comprise two copper layers, adhesive material layers, and/or additional release layers.

According to a further exemplary embodiment, the first component carrier and/or the second component carrier is a coreless component carrier. Thereby, an advantageous component carrier can be efficiently produced as a very thin structure and, in particular, reducing or preventing known problems such as warpage.

A coreless component carrier may be significantly thinner than a component carrier with a massive core structure. Hence, the coreless component carrier may be applied in a more flexible manner, e.g. when being integrated into an electronic assembly. Furthermore, a thin component carrier may dissipate heat in a more efficient manner. As has already been described above, a coreless component carrier is, due to its thin design, prone to bending/warpage during a manufacturing process on the panel level. However, two coreless component carrier, each on a separation surface of a separation component, may represent a stable and robust structure that is improved with respect to the previous issues.

According to a further exemplary embodiment, the first electronic component is placed on a first tape of the first base structure, wherein the method further comprises: removing the first tape after coupling the first base structure with the first separation surface; and/or the second electronic component is placed on a second tape of the second base structure, wherein the method further comprises: removing the second tape after coupling the second base structure with the second separation surface. This may provide the advantage that established technologies can be directly integrated into the production process. The temporary carrier may hold the electronic component in the cavity of the base structure in place. At a later step during the manufacturing process, when the electronic component is already fixed (e.g. embedded in electrically insulating material, then the temporary carrier may be detached.

According to a further exemplary embodiment, the component carrier further comprises a heat distribution layer formed on the low Young modulus layer and facing the main surface of the electronic component. In particular, the heat distribution layer is electrically and thermally connected with the electrically conductive interconnection such that the heat distribution layer and the electrically conductive interconnection at least partially surround the cavity. This may provide the advantage that an efficient heat dissipation for the embedded electronic component is provided.

The electronic component is embedded in an electrically insulating material, typically a resin, which may not comprise feasible thermal conductivity properties. As a consequence, the heat produced by the electronic component cannot be efficiently transported and the electronic component may overheat. This problem may be solved by a heat distribution layer (e.g. made of a metal such as copper or another material with feasible thermal conductivity) formed on the electrically insulating layer. Hereby, the heat distribution layer may be formed on the main surface of the component carrier which is opposite to the main surface that comprises the second electric contacts. In other words, the heat distribution layer may be attached at the main surface of the component carrier which main surface is opposed to the other main surface, where the redistribution structure is formed. The heat distribution layer thus may face the main surface of the electric component which does not comprise the first electric contacts. The heat from the electronic component may be guided through vias (of the electrically conductive interconnection) to the heat distribution layer, wherein the heat distribution layer and the vias are electrically and thermally connected with each other. Hereby, the vias may surround the cavity in which the electronic component has been placed. This may enable an especially efficient heat dissipation. Furthermore, the electric interconnection may connect the heat distribution layer with the redistribution structure. As electrically conductive material such as copper generally comprises feasible thermally conductivity, already existing electrical connections may at the same time be used as efficient heat dissipation structures.

According to a further exemplary embodiment, the whole structure of two component carriers and a separation component (i.e. the semi-finished product) may be around 400 µm thick. According to another embodiment, a single build-up layer (i.e. one of the component carriers) may have a thickness below 70 µm. In a further embodiment, each of the two component carriers may have a thickness below 70 µm.

According to an exemplary embodiment, the electronic component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), a die, an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, a logic chip, a light guide, and an energy harvesting unit. However, other components may be embedded in or surface mounted on the component carrier. For example, a magnetic element can be used as a component. Such a magnetic element may be a permanent magnetic element (such as a ferromagnetic element, an antiferromagnetic element or a ferromagnetic element, for instance a ferrite coupling structure) or may be a paramagnetic element. However, the component may also be a substrate, an interposer or a further component carrier, for example in a board-in-board configuration. Moreover, also other components, in particular those which generate and emit electromagnetic radiation and/or are sensitive with regard to electromagnetic radiation propagating from an environment, may be used as component.

According to an exemplary embodiment, the at least one electrically insulating (layer) structure comprises at least one of the group consisting of resin (such as reinforced or non-reinforced resins, for instance epoxy resin or Bismaleimide-Triazine resin, cyanate ester, polyphenylene derivate, glass (in particular glass fibers, multi-layer glass, glass-like materials), prepreg material (such as FR-4 or FR-5), polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg particularly FR4 are usually preferred for rigid PCBs, other materials in particular epoxy-based Build-Up Film for substrates for substrates may be used as well. For high frequency applications, high-frequency materials such as polytetrafluoroethylene, liquid crystal polymer and/or cyanate ester resins, low temperature cofired ceramics (LTCC) or other low, very low or ultra low DK-materials may be implemented in the component carrier as electrically insulating layer structure.

According to an exemplary embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

According to an exemplary embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

According to an exemplary embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg such as FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing particles (such as reinforcing spheres, in particular glass spheres).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres). Furthermore, the component carrier may be configured as a substrate-like-printed circuit board (SLP).

The substrate or interposer may consist of at least a layer of glass, Silicon (Si) or a photoimageable or dry-etchable organic material like epoxy-based Build-Up films or polymer compounds like Polyimide, Polybenzoxazole, or Benzocyclobutene.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

The aspects defined above and further aspects of the invention are apparent from the examples of embodiment to be described hereinafter and are explained with reference to these examples of embodiment.
Figures 1a to 1i illustrate exemplary embodiments of a method of manufacturing component carriers according to embodiments of the invention.
Figures 2a to 2d illustrate a prior art process (see description aove).
Figures 3a to 3c illustrate specific advantageous effects according to exemplary embodiments of the invention.
Figures 4a to 4d illustrate exemplary embodiments of component carriers that may be manufactured with the method and / or deriving from the semi-finished product according to the invention.
Figures 5a to 5k illustrate exemplary embodiments of the method of manufacturing component carriers according to a further embodiment of the invention.
Figures 6a to 6k illustrate exemplary embodiments of the method of manufacturing component carriers according to a further embodiment of the invention.
Figures 7a to 7i illustrate exemplary embodiments of the method of manufacturing component carriers according to a further embodiment of the invention.
Figures 8a to 8c illustrate an example of a method of manufacturing component carriers.
Figures 9a to 9i illustrate an example of a method of manufacturing component carriers.
Figures 10a to 10j illustrate an example of a method of manufacturing component carriers.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, the following steps are included in the manufacturing process: i) providing a low cost detach core (DCF) sandwiched between two prepreg (PPG) layers, ii) performing a lay-up using two base structures (comprising each an electronic component on a temporary carrier), iii) hot pressing (laminating) and trimming (cutting edges), iv) de-taping the temporary carrier and performing a first step of layer build-up, v) performing a second step of layer build-up, vi) providing surface finish and solder resist, vii) again trimming and then detaching the component carriers from the DCF, and viii) attaching a heat distribution layer at the PPG layer and provide solder balls to the redistribution structure.

As known, a fan-out wafer level packaging (FOWLP) is one of the latest packaging trends in microelectronics. It has a high potential for significant package miniaturization concerning package volume but also its thickness. Technological core of FOWLP is the formation of a reconfigured molded wafer combined with a thin film redistribution layer to yield an SMD-compatible package. Main advantages of FOWLP are the substrate-less package, low thermal resistance, improved RF performance due to shorter interconnects together with direct IC connection by thin film metallization instead of wire bonds or flip chip bumps and lower parasitic effects. Especially the inductance of FOWLP is much lower compared to FC-BGA packages. In addition, the redistribution layer can also provide embedded passives as well as antenna structures using a multi-layer structure. It can be used for multi-chip packages for system-in-package (SiP) and heterogeneous integration. For higher productivity and resulting lower cost, larger mold embedding form factors are forecast for the near future. Besides increasing wafer diameter, an alternative option would be moving to panel sizes leading to fan-out panel level packaging (FOPLP). Panel sizes could range from 18" x 24" (a PCB manufacturing standard) to even larger sizes. However, a FO-PLP (fan-out panel level packaging) substrate embedding the functional chip needs an efficient thermal management to facilitate smooth chip operation. An object of the invention is hence to provide a high yield production method for single side build FO-PLP products with thin core (i.e. component carriers) using DCF (detach copper foil) as a separation component. The resulted FO-PLP products have an enhanced heat dissipation capacity by surrounding the cavity with the embedded component with heat spread metal (e.g. an electrically conductive interconnection) and a heat dissipation layer (e.g. a heat distribution layer) on the top layer. The heat spread metal and the heat dissipation layer are hereby interconnected by one or more vias.

Due to the present invention, in particular when placing the electronic components in the cavities after the base structures have been coupled with the separation component, the following advantages may be provided: i) solving the tape (temporary carrier) twisty issue and make sure it is flat during front side encapsulation, especially for a large component-package ratio, ii) prevent the movement or deformation during lamination, iii) flexible application and more efficiency on first lamination or hot press; two panels (component carriers) proceed at one time is possible, iv) warpage performance becomes better during and after first lamination, v) applying the thermal released adhesive may help to reduce the risk of leaving residuals, and vi) making it more feasible to remove the temporary adhesive layer or carrier (temporary carrier or separation component) with a thermal release adhesive.

According to an exemplary embodiment of the invention, the following steps are performed: i) laminating a double side adhesive (adhesive material) on two sides of a separation component (could be a FR4 material with 400 µm thickness), ii) attaching the base structures with completed cavity and pattern on two sides of the separation component, iii) proceeding the pick & place process for both cores on two sides, iv) proceeding the first lamination or hot press or both cores on two sides at the same time, v) removing the separation component by additional thermal treatment or merely removing it after a lamination step or a hot press process (based on the adhesive selection and process flow requirements), and vi) continuing the further processes as normal CCE (Center Core Embedded) process, laminating or hot pressing on the back side or both sides.

In the following description of exemplary embodiments, generally a double-side build-up (from both separation surfaces of the separation component) is described. As alternative embodiment not covered by the present invention, each of these processes can also be performed with a single-side build-up, i.e. using just one separation surface of the separation component to build just one component carrier. In this case, it may be reasonably sufficient if the separation component has only one separation surface on that surface which is used for realizing the build-up.

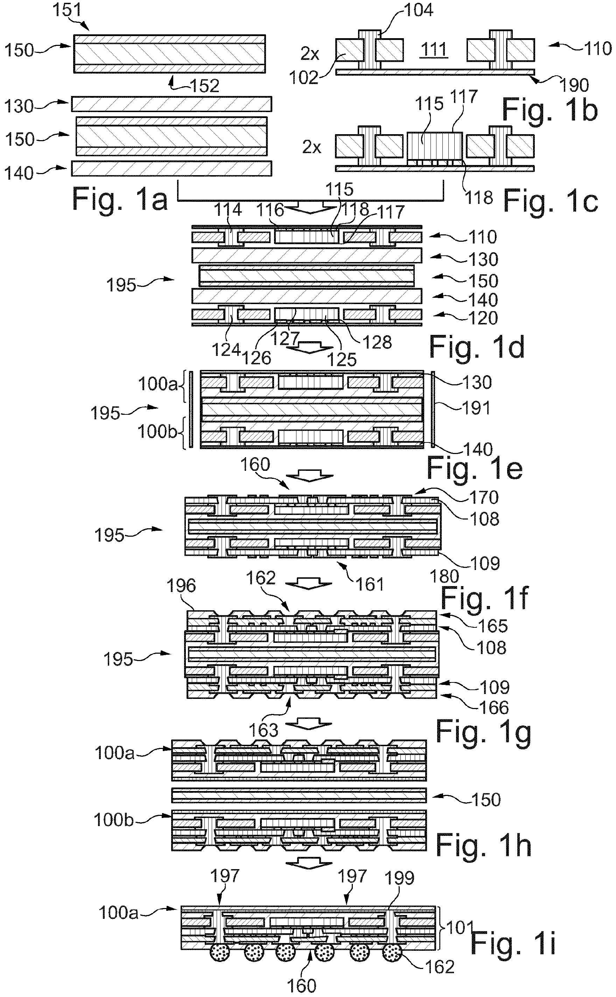

**Figures 1a to 1i** illustrate exemplary embodiments of a method for manufacturing a first component carrier 100a and a second component carrier 100b.

Figure 1a: A separation component 150 comprising a first separation surface 151 and a second separation surface 152, which is opposed to the first separation surface 151, is provided. The separation component 150 is a detachment core, wherein a core structure of electrically insulating material is sandwiched between two copper foils which are prone to enable later-on feasible detachment properties. In another embodiment, the separation component 150 comprises a dummy core sandwiched between two dummy insulator layers which are respectively covered by separation copper foils. The dummy core may hereby comprise a through-via structure. A first electrically insulating layer 130 is then laminated directly on the first separation surface 151 of the separation component 150 and a second electrically insulating layer 140 is laminated directly on the second separation surface 152. The first electrically insulating layer 130 and the second electrically insulating layer 140 are formed of a prepreg material with a low Young modulus, i.e. a Young modulus of less than 10 GPa. Hereby, the first electrically insulating layer 130 and the second electrically insulating layer 140 consist of prepreg material with a Young modulus around 7 GPa (for example TD002 or Dusan).

Figure 1b: A first base structure 110 and a second base structure 120 are provided (only the first base structure is shown in this Figure). Each base structure 110, 120 comprises an electrically insulating layer structure 102 and an electrically conductive layer structure 104, the last in form of interconnection vias. Furthermore, each base structure 110, 120 comprises a cavity 111, 121 formed in the electrically insulating layer structure 102. In order to provide a space for accommodating an electronic component, each base structure 110, 120 comprises a temporary carrier 190 arranged below the electrically insulating layer structure 102 and the cavity 111, 121.

Figure 1c: A first electronic component 115 is placed in the first cavity 111 such that the electronic component 115 is attached to the temporary carrier 190. The electronic component 115 comprises a first main surface 117 without electric contacts that faces away from the temporary carrier 190. The electronic component 115 comprises a further first surface 118, opposed to the first main surface 117, which comprises first electric contacts 116. Hereby, the first electric contacts 116 are attached to the temporary carrier 190. Furthermore, the same procedure is performed for the second base structure 120, whereby a second electronic component 125 with second electric contacts 126 is placed into the cavity 121 (not shown). In this exemplary embodiment, the electronic component 115, 125 is placed in the cavity 111, 121 before the base structure 110, 120 is coupled with the separation component 150. However, in another embodiment, the electronic component 115, 125 may be placed in the cavity after the base structure 110, 120 has been coupled with the separation component 150.

In an embodiment (not shown in this Figure), the first electronic component 115 is at least partially embedded (using an electrically insulating material) in the first cavity 111 of the first base structure 110 before attaching the first base structure 110 on top of the first electrically insulating layer 130 and/or the second electronic component 125 is at least partially embedded (using an electrically insulating material) in the second cavity 121 of the second base structure 120 before attaching the second base structure 121 on top of the second electrically insulating layer 140.

Figure 1d: The first base structure 110 is coupled to the first separation surface 151 and the second base structure 120 is coupled to the second separation surface 152 of the separation component 150. The coupling is done by attaching the first base structure 110 directly on top of the first electrically insulating layer 130 and attaching the second base structure 120 directly on top of the second electrically insulating layer 140. The first base structure 110 is hereby attached on top of the first electrically insulating layer 130 such that the first main surface 117 of the first electronic component 115 is directly attached to the first electrically insulating layer 130, and the second base structure 120 is attached on top of the second electrically insulating layer 140 such that the second main surface 127 of the second electronic component 125 is directly attached to the second electrically insulating layer 140. In this manner, a semi-finished product 195 is obtained. The electrically insulating layers 130, 140 are made of prepreg, i.e. they are in an uncured state. In the uncured state the material is to some extent deformable so that the base structures 110, 120 can be pressed into the prepreg layers 130, 140. In this manner, first electrically conductive pillar structures 114 of the first base structure 110 pierce into the first electrically insulating layer 130 and second electrically conductive pillar structures 124 of the second base structure 120 pierce into the second electrically insulating layer 140. Also the first and second electronic components 115, 125 can be pressed into the electrically insulating layers 130, 140, respectively, such that they pierce the uncured prepreg material 130, 140. Thereby, the electronic components 115, 125 can be embedded in the prepreg material 130, 140.

Figure 1e: a lamination step is then performed by applying temperature and/or pressure. The prepreg material of the electrically insulating layers 130, 140 is cured in this manner. Thereby, tight connections between the electrically insulating layers 130, 140 and the respective base structures 110, 120 are formed. Furthermore, the first electronic component 115 becomes embedded in the first electrically insulating layer 130 and the second electronic component 125 becomes embedded in the second electrically insulating layer 140. At this stage, the electronic components 115, 125 can be considered as being in connection to their respective base structure 110, 120. Hence, the base structures 110, 120 could also already be termed first component carrier 100a and second component carrier 110b, respectively. Because the area of the separation component 150 is slightly smaller than the area of the base structures 110, 120 and of the electrically insulating layers 130, 140 (for example 510*515 mm for base structures and electrically insulating layers and 508*513 mm for the separation component), a step of trimming (removing) of the edges 191 is performed so that all layers have the same area size.

Figure 1f: at this point, the temporary carriers 190 can be removed. Then, a first further electrically insulating layer structure 108 is laminated on the base structure 110. Additionally, a second further electrically insulating layer structure 109 is laminated on the second base structure 120. Alternatively, an electrically conductive (metal) layer can be applied by sputtering followed by the application of chemical copper and/or galvanic copper (e.g. performing a plating process). A further possibility is to start directly with chemical copper instead of sputtering. First electrically conductive interconnections 170 in form of first vias and metal layers are formed through the first further electrically insulating layer structure 108, in order to electrically contact the first electric contacts 116 of the first electronic component 115. The same is done using second electrically conductive interconnections 180 through the second further electrically insulating layer structure 109, in order to electrically contact the first electric contacts of the second electronic component 125. In this manner, a first redistribution structure 160 is formed at the first component carrier 100a and a second redistribution structure 161 is formed at the second component carrier 100b. The described procedure of Figure 1f could be repeated one or more times. Hereby, other further electrically insulating layer structures may be laminated on top of the further first and second electrically insulating layer structures 108, 109 and other electrically conductive interconnections may be formed through these layers.

Figure 1g: the main surfaces 165, 166 of the semi-finished product 195 receive a solder resist layer 196.

Figure 1h: after a further trimming step, the first component carrier 100a and the second component carrier 100b are separated from the separation component 150. In particular, the first component carrier 100a and the second component carrier 100b are respectively detached from the first separation side 151 and the second separation side 152. Because the electrically insulating layers 130, 140 are tightly connected to the component carriers 100a, 100b after curing, said layers do not attach to the separation component 150 anymore after separation.

Figure 1i: the final component carrier 100a (the same description holds true for the component carrier 100b not shown) is a coreless component carrier and comprises a layer stack 101 comprising electrically conductive layer structures 104 and electrically insulating layer structures 102. Hereby, one electrically insulating layer structure 130 is a low Young modulus layer structure formed of a low Young modulus material. Furthermore, the layer stack 101 is at least partially formed as a redistribution structure 160. The electronic component 115 embedded in the cavity 111 of the layer stack 101 is electrically connected with the redistribution structure 160 such that the first electric contacts 116 of the electronic component 115 are transferred via the redistribution structure 160 to second electric contacts 162 at the main surface 165 of the layer stack 101. The second electric contacts 162 are formed as solder balls and are larger than the first electric contact 116. The electronic component 115 is arranged directly between, the low Young modulus layer structure 130 and the redistribution structure 160. Especially, the electronic component 115 is embedded in the low Young modulus layer structure 130. In a last step, a heat distribution layer 199, e.g. a metal layer made of copper, is attached below the electrically insulating layer 130. The heat distribution layer 199 is connected to the electrically conductive interconnection 170 of the component carrier 100a. In particular, the heat distribution layer 199 electrically and thermally connected to vias that reach through the component carrier 100a. The electrically conductive interconnection 170 can also connect the heat distribution layer 199 is the redistribution structure 160. In this manner, the heat distribution layer 199 efficiently dissipates heat produced by the embedded electronic component 115. In a last step, a surface finish 197 is provided on top of the heat distribution layer 199.

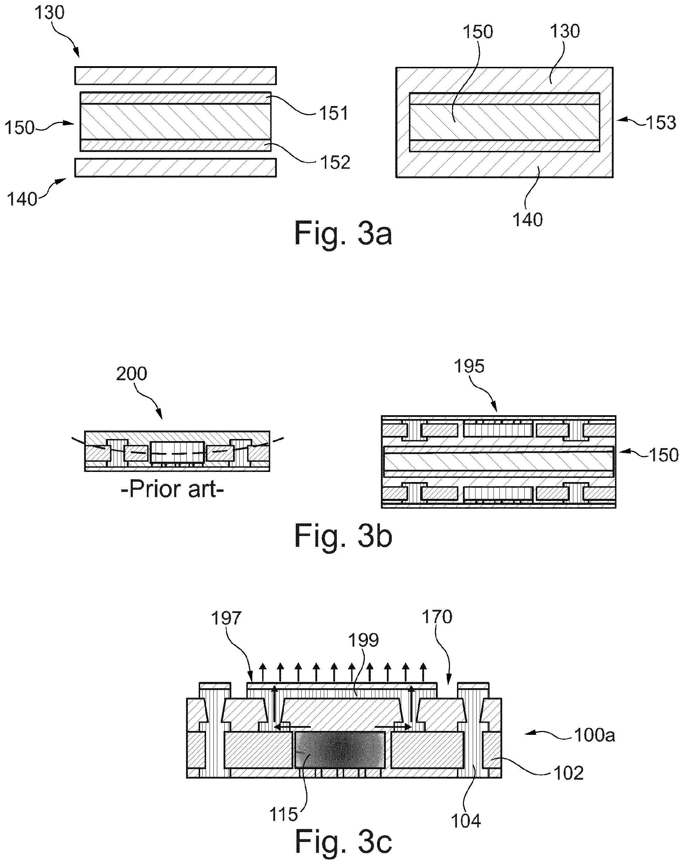

Figures 3a to 3c show specific advantages of exemplary embodiments of the invention.

Figure 3a: the electrically insulating layers 130, 140 are attached to the first separation surface 151 and to the second separation surface 152, respectively, of the separation component 150, e.g. a detach copper foil (DCF) as has already been described above. In the present embodiment, the area size of the electrically insulating layers 130, 140 is larger than the area size of the separation component 150. Thus, the separation component 150 can also be laminated at the sides 153 with the electrically insulating layers 130, 140. As a consequence, the separation component 150 can be fully surrounded by the electrically insulating layers 130, 140, i.e. prepreg material. In this manner, an undesired separation of the electrically insulating layers 130, 140 and the separation component 150 is efficiently prevented.

Figure 3b: at the left side there is an example of a printed circuit board 200 from the prior art shown (see also Figure 2 above). The lamination of further layers is asymmetrical according to the prior art and thus, problems with respect to bending/warpage (shown by dotted line) occur. Hence, thick core structures have to be used. At the right side there is shown a semi-finished product 195 according to an exemplary embodiment of the invention. Lamination is done in a symmetrical manner above and below the separation component 150. Because the semi-finished product 195 already comprises a certain thickness, there is no need for a core structure. As a result, coreless structures can be used without issues regarding warpage.

Figure 3c: a component carrier 100a is shown which comprises an embedded component 115. The component 115 produces heat which can be efficiently dissipated using the electrically conductive material (e.g. copper) of the electrically conductive interconnection 170 which are present anyway in the component carrier 100a. The electrically conductive interconnection 170 comprises vias which are electrically connected to a heat distribution layer 199. The heat distribution layer 199 may be formed of metal (e.g. copper) or another material with a high thermal conductivity, e.g. diamond-like carbon or aluminum nitride. Furthermore, the heat distribution layer 199 may be covered with a surface finish 197. The heat distribution layer 199 and the vias of the electrically conductive interconnection 170 are electrically and thermally connected such that the heat distribution layer 199 and the electrically conductive interconnection 170 at least partially surround the cavity 111 in which the electronic component 115 is placed. In this manner, an efficient heat dissipation is provided, even though the electronic component 115 is embedded in a thick layer of electrically insulating material (which generally comprises a very low thermal conductivity).

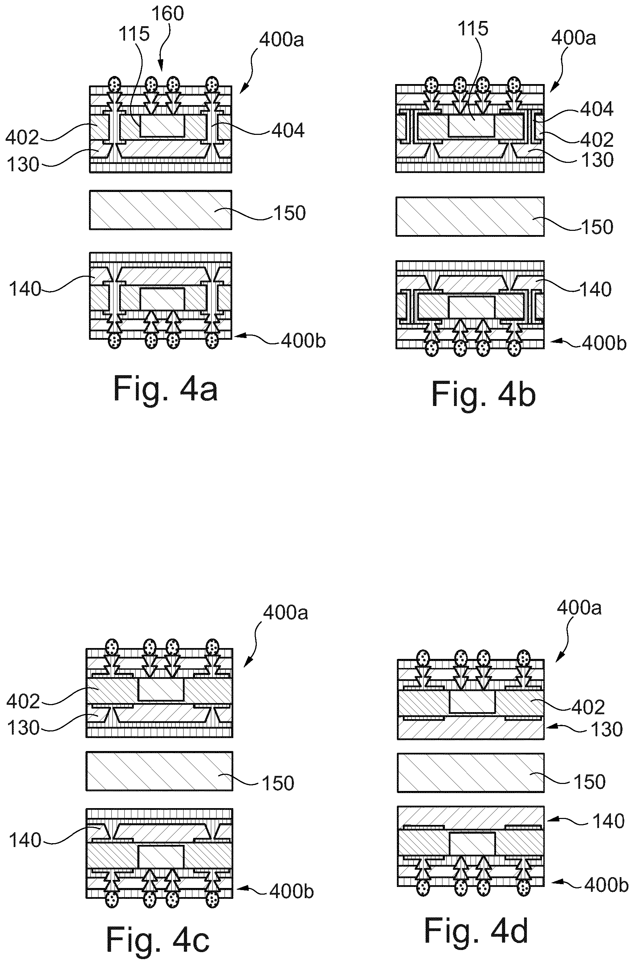

Figures 4a to 4d show exemplary embodiments of component carriers not covered by the present invention, wherein the component carrier application depends on the core type and the front side structure. The component carriers 400a, 400b are shown directly after separation from a separation component 150. The component carriers 400a, 400b comprise each an embedded electronic component 115 which is sandwiched between a redistribution structure 160, 161 and an electrically insulating layer 130, 140.

Figure 4a: an LTH (laser through hole) core 402 is applied with completely filled vias 404 as through-hole connections.

Figure 4b: a PTH (plated through hole) core 402 is applied with not completely filled vias 404 as through-hole connections.

Figure 4c: a core structure 402 is applied without a through-hole connection.

Figure 4d: a core structure (no PTH core) 402 is applied. The electrically insulating layers 130, 140 are not covered by a further layer.

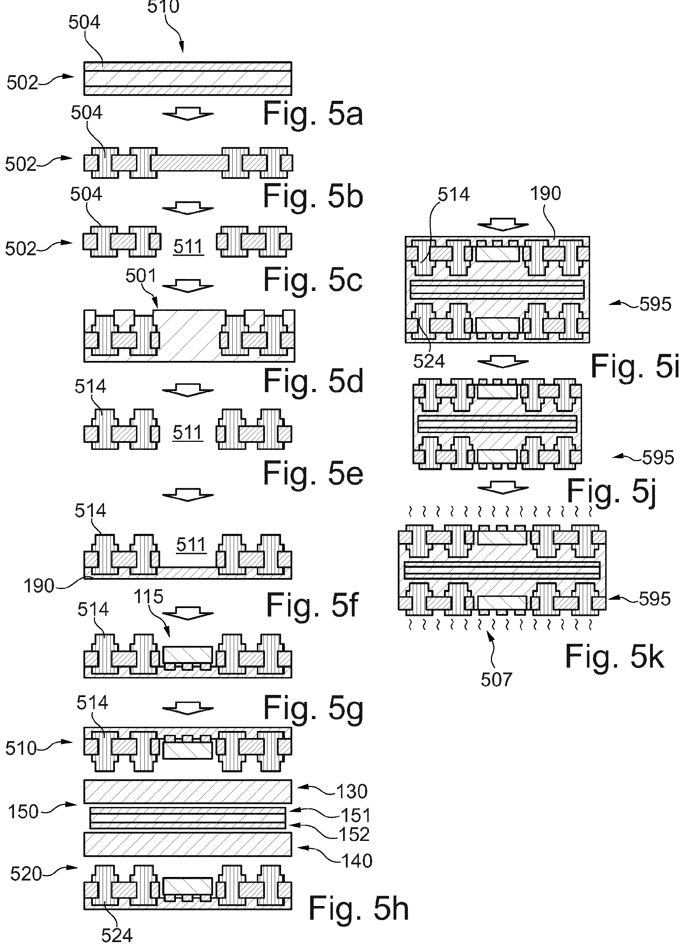

Figures 5a to 5k show exemplary embodiments of a further method of manufacturing component carriers.

Figure 5a: a base structure 510 is provided comprising an electrically insulating layer structure 502 sandwiched between two electrically conductive layer structures 504, i.e. a copper-clad laminate (CCL).

Figure 5b: holes are drilled through the base structure 510 and are consequently filled with electrically conductive material 504 in order to form vias (LTH patterning).

Figure 5c: a cavity 511 is formed in the center of the base structure 510, e.g. by laser drilling, sand-blasting, or other known methods.

Figure 5d and 5e: the vias 504 are enlarged to (copper) pillar structures 514 using known methods.

Figure 5f: a temporary carrier 190 is attached to the base structure 510 at the opposite side of the pillar structures 514.

Figure 5g: an electronic component 115 is placed into the cavity 511 and onto the temporary carrier 190.

Figure 5h: the base structure 510 and a further base structure 520 are coupled to the two separation surfaces 151, 152, respectively, of a separation component 150. Between the separation surfaces 151, 152 and the base structures 510, 520 there are arranged electrically insulating layers 130, 140 of (uncured) prepreg material.

Figure 5i: the base structures 510, 520 have been pressed into the uncured electrically insulating layers 130, 140 such that the pillar structures 514, 524 pierce into the electrically insulating layers 130, 140, respectively, and the electronic components 115, 125 become embedded by the electrically insulating layers 130, 140. Using a lamination process (high temperature and pressure), the prepreg material becomes cured and a semi-finished product 595 is obtained. The base structures 510, 520 are now connected to their respective electronic component 115, 125 and can be termed component carriers.

Figure 5j: the temporary carrier 190 is removed.

Figure 5k: an additional plasma 507 step is performed to the main surfaces of the semi-finished product 595. The purpose of the plasma process is to remove temporary carrier residues and clean electric contacts.

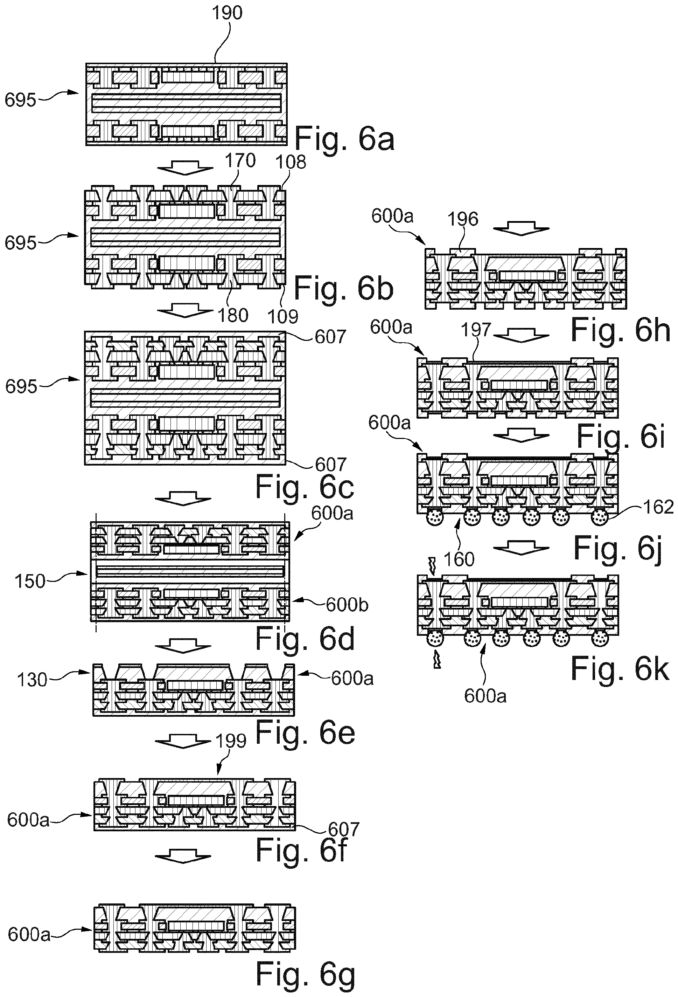

Figures 6a to 6k show exemplary embodiments of a further method of manufacturing component carriers.

Figure 6a: a semi-finished product 695 (e.g. as described above) is provided.

Figure 6b: the temporary carrier 190 is detached and, after a step of plasma treatment, a first layer build-up is performed. Thereby, further electrically insulating layer structures 108, 109 are laminated and electrically conductive interconnections 170, 180 are provided.

Figure 6c: a second layer build-up step is performed and a protection film 607 (e.g. polyimide) is provided.

Figure 6d: the edges are trimmed and the component carriers 600a, 600b are detached from the separation component 150.

Figure 6e: holes are drilled through the electrically insulating layer 130 using X-ray and/or laser drilling.

Figure 6f: the holes are filled with electrically conductive material in order to form vias and a heat distribution layer 199 is formed on the electrically insulating layer 130.

Figure 6g: the protection film 607 is removed.

Figure 6h: a solder resist 196 is provided at both sides.

Figure 6i: a surface finish layer 197 is provided at both sides.

Figure 6j: second electric contacts 162 are formed at the main surface 165 of the component carrier 600a. The contacts 162 are formed as solder balls and the redistribution structure 160 is finished.

Figure 6k: an electric check (shown symbolically with a flash) is performed in order to finish the component carrier 600a.

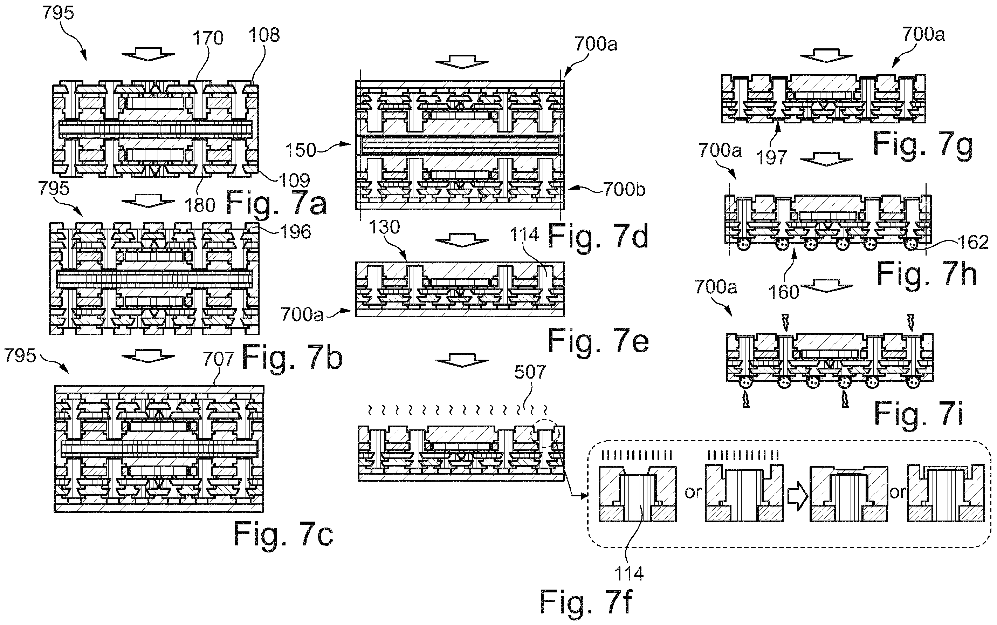

Figures 7a to 7i show exemplary embodiments of a further method of manufacturing component carriers.

Figure 7a: a semi-finished product 795 (e.g. as described above) is provided and a first layer build-up is performed. Thereby, further electrically insulating layer structures 108, 109 are laminated and electrically conductive interconnections 170, 180 are provided.

Figure 7b: a second layer build-up step is performed and solder resist 196 is provided.

Figure 7c: a protection film 707 (e.g. polyimide) is provided.

Figure 7d: the edges are trimmed and the component carriers 700a, 700b are detached from the separation component 150.

Figure 7e and 7f: copper etching and/or laser direct ablation (LDA) are used to pattern the surface of the electrically insulating layer 130 and the pillar structures 114 pierced there into. On the right side of Figure 7f, there are two embodiments shown after performing the LDA step. Further to the right side, there are two embodiments shown after performing an additional ENEPIG (electroless nickel electroless palladium immersion gold) step. Then, an additional plasma 507 step is performed to the main surfaces of the component carrier 700a.

Figure 7g: a surface finish 197 is provided.

Figure 7h: a further trimming step is performed and second electric contacts 162 are formed at the main surface 165 of the component carrier 700a. The contacts 162 are formed as solder balls and the redistribution structure 160 is finished.

Figure 7i: an electric check (shown symbolically with flashes) is performed in order to finish the component carrier 700a.

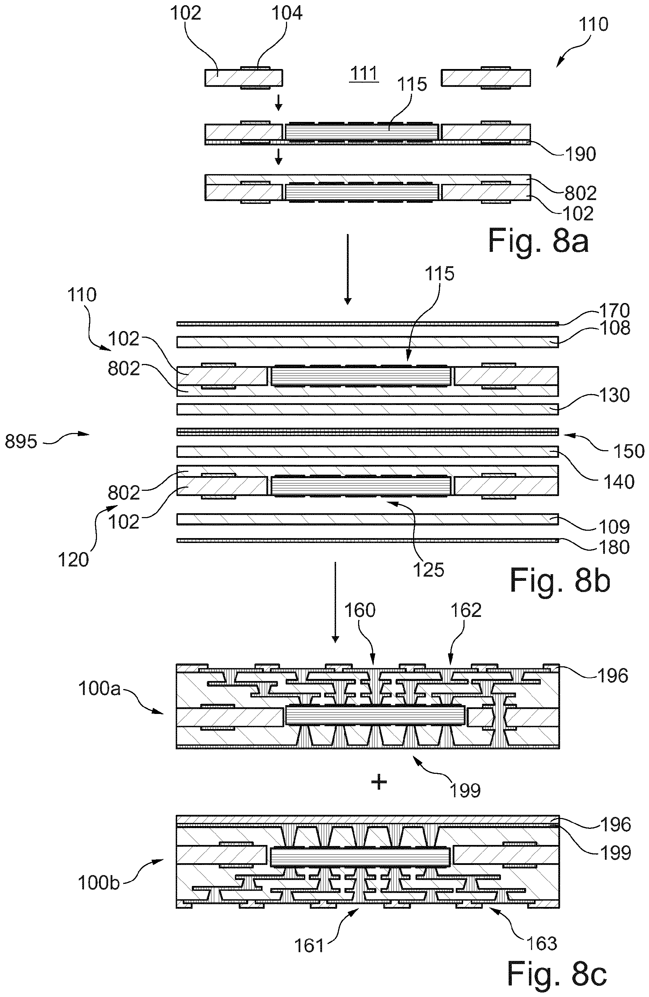

Figures 8a to 8c show an example not covered by the present invention of a further method of manufacturing component carriers.

Figure 8a: a first base structure 110, comprising an electrically insulating structure 102 and an electrically conductive structure 104, is provided. A first electronic component 115 is placed in a cavity 111 in the electrically insulating structure 102 and is fixed using a temporary carrier 190. Then, the first electronic component 115 is (at least partially) embedded/encapsulated, using an electrically insulating material 802, in the first cavity 111 of the first base structure 110. Then the temporary carrier 190 is removed.

Figure 8b: the first base structure 110 with the embedded electronic component 115 is attached on top of a first electrically insulating layer 130 of a separation component 150. Hereby, the electronic component 115 is already embedded in an electrically insulating material 802. The same is done for a second electronic component 125 which is (at least partially) embedded (using a further electrically insulating material 802) in a second cavity 121 of a second base structure 120, before the second base structure 121 is attached on top of the second electrically insulating layer 140 of the separation component 150. Later on, further electrically insulating structures 108, 109 and additional electrically conductive structures 170, 180 are attached on top of the base structures 110, 120, respectively. Alternatively, an electrically conductive (metal) layer can be applied by sputtering followed by the application of chemical copper and/or galvanic copper (e.g. performing a plating process). A further possibility is to start directly with chemical copper instead of sputtering. Layer build-up is done using known methods such as subtractive, mSAP or SAP.

Figure 8c: two component carriers 100a, 100b are detached from the separation component 150. These component carriers 100a, 100b show an asymmetric build-up with a respective redistribution structure 160, 161 on one side of the respective component 115, 125, and a respective heat distribution layer 199 on the opposed side of the respective electronic component 115, 125. While the first component carrier 100a has an exposed heat distribution layer 199, the second component carrier 100b comprises a layer of solder resist 196 over the heat distribution layer 199.

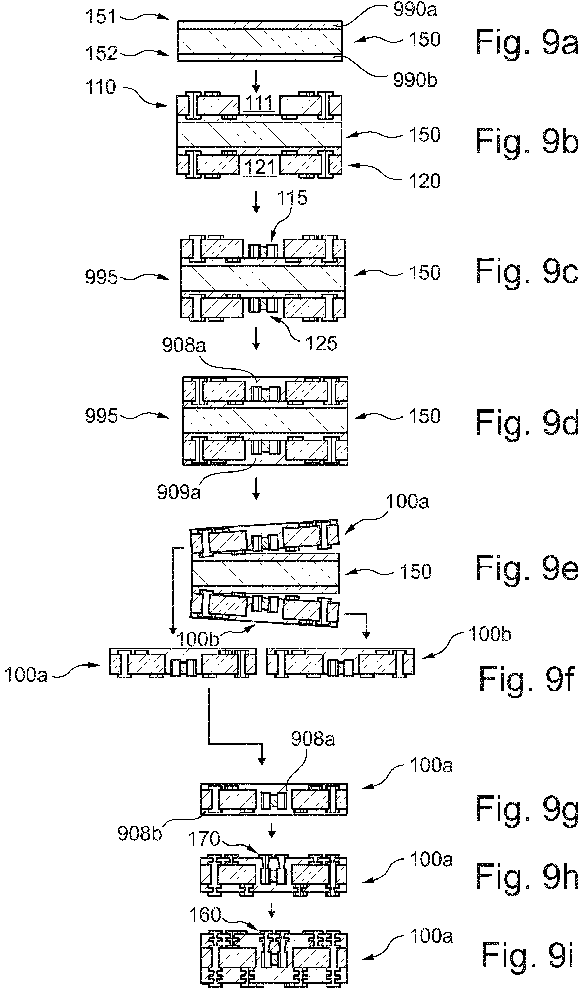

Figures 9a to 9i show an example not covered by the present invention of a further method of manufacturing component carriers. While a double-side build-up (from both separation surfaces of the separation component) is described in the following, the whole process can also be performed with a single-side build-up, i.e. using just one separation surface of the separation component to build the component carrier.

Figure 9a: a separation component 150 is provided. The separation sides 151 and 152 are covered by a first temporary carrier 990a and a second temporary carrier 990b, respectively, which are constructed to allow a temporary adhering.

Figure 9b: a first base structure 110 is coupled with the first separation surface 151 such that a first cavity 111 is provided, and a second base structure 120 is coupled with the second separation surface 152 such that a second cavity 121 is provided.

Figure 9c: a first electronic component 115 is placed into the first cavity 111 and is adhered to the first temporary carrier 990a. Furthermore, a second electronic component 125 is placed into the second cavity 121 and is adhered to the second temporary carrier 990b. In this manner, a semi-finished product 995 is obtained.

Figure 9d: the first base structure 110 is laminated with a further electrically insulating layer structure 908a so that the first electronic component 115 is embedded in the material of the further electrically insulating layer structure 908a. Furthermore, the second base structure 120 is laminated with a further electrically insulating layer structure 909a so that the second electronic component 125 is embedded in the material of the further electrically insulating layer structure 909a.

Figures 9e and 9f: a first component carrier 100a and a second component carrier 100b are detached from the separation component 150. Optionally this step is accompanied by thermal treatment. The temporary carriers 990a, 990b do hereby not adhere to the component carriers 100a, 100b anymore.

Figure 9g: a further electrically insulating layer structure 908b is laminated to the backside of the first component carrier 100a so that the first electronic component 115 becomes fully embedded.

Figure 9h: a first electrically conductive interconnection 170, comprising a plurality of vias, is formed through the first further electrically insulating layer structure 908a, in order to electrically contact a first electric contact of the first electronic component 115.

Figure 9i: after a second lamination and electrically contacting step, the final component carrier 100a is provided with a first redistribution structure 160.

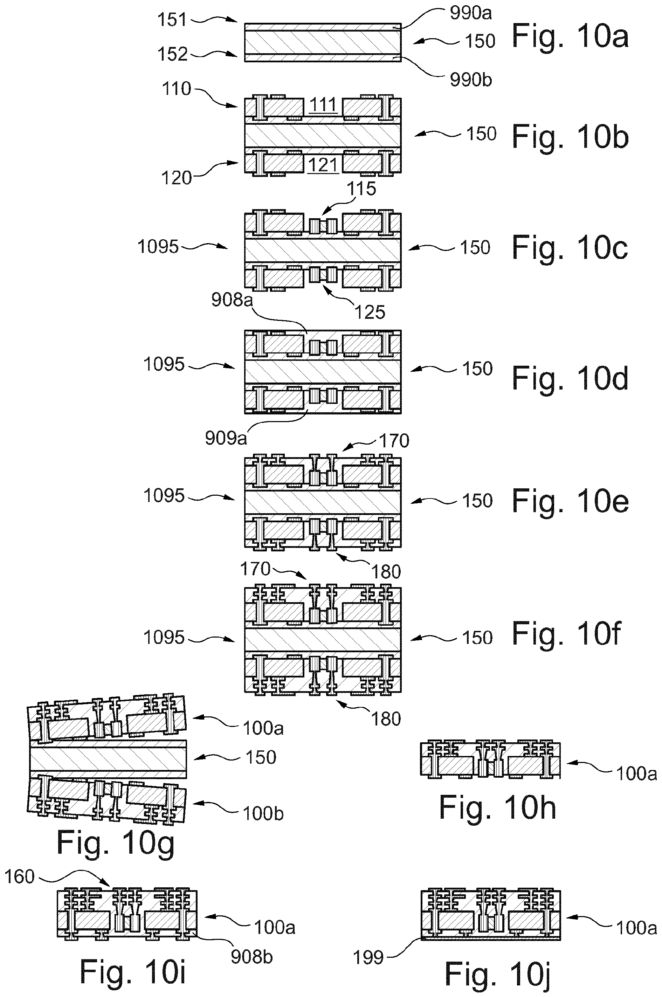

Figures 10a to 10j show an example not covered by the present invention of a further method of manufacturing component carriers. While a double-side build-up (from both separation surfaces of the separation component) is described in the following, the whole process can also be performed with a single-side build-up, i.e. using just one separation surface of the separation component to build the component carrier.

Figure 10a: a separation component 150 is provided. The separation sides 151 and 152 are covered by a first temporary carrier 990a and a second temporary carrier 990b, respectively. These function as an adhesive material.

Figure 10b: a first base structure 110 is coupled with the first separation surface 151 such that a first cavity 111 is provided, and a second base structure 120 is coupled with the second separation surface 152 such that a second cavity 121 is provided.

Figure 10c: a first electronic component 115 is placed into the first cavity 111 and is adhered to the first temporary carrier 990a. Furthermore, a second electronic component 125 is placed into the second cavity 121 and is adhered to the second temporary carrier 990b. Hereby, a semi-finished product 1095 is obtained.

Figure 10d: the first base structure 110 is laminated with a further electrically insulating layer structure 908a so that the first electronic component 115 is embedded in the material of the further electrically insulating layer structure 908. Furthermore, the second base structure 120 is laminated with a further electrically insulating layer structure 909a so that the second electronic component 125 is embedded in the material of the further electrically insulating layer structure 909a.

Figure 10e: a first electrically conductive interconnection 170, comprising a plurality of vias, is formed through the first further electrically insulating layer structure 908a, in order to electrically contact a first electric contact of the first electronic component 115. Furthermore, a second electrically conductive interconnection 180, comprising a plurality of vias, is formed through the second further electrically insulating layer structure 909a, in order to electrically contact a first electric contact of the second electronic component 125.

Figure 10f: a further step of laminating and electrically contacting is performed.

Figures 10g and 10h: a first component carrier 100a and a second component carrier 100b are detached from the separation component 150. Optionally this step is accompanied by thermal treatment. The temporary carriers 990a, 990b do hereby not adhere to the component carriers 100a, 100b. The component carrier 100a comprises a first redistribution structure 160.

Figure 10i: a further lamination and electrically contacting step is performed. A further electrically insulating layer structure 908b is laminated to the backside of the first component carrier 100a so that the first electronic component 115 becomes fully embedded.

Figure 10j: the final component carrier 100a is provided with a heat distribution layer 199.

### Reference signs

100a, 400a, 600a, First component carrier
700a,
100b, 400b, 600b, Second component carrier
700b
101 Layer stack
102, 402, 502 Electrically insulating layer structure
104, 404, 504 Electrically conductive layer structure
108, 908a, 908b First further electrically insulating layer structure
109, 909a Second further electrically insulating layer structure
110, 510 First base structure
111, 511 First cavity
114, 514 First pillar structure
115 First electronic component
116 First electric contact
117 Main surface of first electronic component
118 Further main surface of first electronic component
120, 520 Second base structure
121 Second cavity
124, 524 Second pillar structure
125 Second electronic component
126 Further first electric contact
127 Main surface of second electronic component
130 First electrically insulating layer/ low Young modulus layer structure
140 Second electrically insulating layer
150 Separation component
151 First separation surface
152 Second separation surface
153 Sidewall of separation component
160 First redistribution structure
161 Second redistribution structure
162 Second electric contact
163 Further second electric contact
165 Main surface of component carrier
166 Further main surface of component carrier
170 First electrically conductive interconnection
180 Second electrically conductive interconnection
190 Temporary carrier
191 Edge part
195, 595, 695, 795, 895 Semi-finished product
995, 1095
196 Solder resist
197 Surface finish
199 Heat distribution layer
200 Prior art core structure
202 Prior art electrically insulating layer
204 Prior art electrically conductive structure
208, 209 Prior art embedding material
215 Prior art chip
290 Prior art tape
507 Plasma
607, 707 Protection layer
802 Electrically insulating material for embedding
990a First temporary carrier
990b Second temporary carrier

## Claims

1. A method of manufacturing a first component carrier (100a) and a second component carrier (100b), the method comprising:
providing a separation component (150) comprising a first separation surface (151) and a second separation surface (152) being opposed to the first separation surface (151);
coupling a first base structure (110) having a first cavity (111) with the first separation surface (151);
coupling a second base structure (120) having a second cavity (121) with the second separation surface (152);
placing a first electronic component (115) in the first cavity (111);
connecting the first base structure (110) with the first electronic component (115) to form the first component carrier (100a);
placing a second electronic component (125) in the second cavity (112);
connecting the second base structure (120) with the second electronic component (125) to form the second component carrier (100b);
separating the first component carrier (100a) from the first separation surface (151) of the separation component (150);
separating the second component carrier (100b) from the second separation surface (152) of the separation component (150);
forming a first electrically insulating layer (130) on the first separation surface (151) before coupling the first base structure (110) with the first separation surface (151), and afterwards
attaching the first base structure (110) on the first electrically insulating layer (130); and
forming a second electrically insulating layer (140) on the second separation surface (152) before coupling the second base structure (120) with the second separation surface (152), and afterwards
attaching the second base structure (120) on the second electrically insulating layer (140);
**characterized in that**
the electrically insulating layers (130, 140) have a larger area size than the separation component (150) and the separation component (150) is laminated at the sides (153) with the electrically insulating layers (130, 140), such that the sidewalls of the separation component (150) are covered.

2. The method according to claim 1, wherein the method further comprises:
laminating the first electrically insulating layer (130) on the first separation surface (151); and
laminating the second electrically insulating layer (140) on the second separation surface (152).

3. The method according to claim 1 or 2,
wherein the first electrically insulating layer (130) and the second electrically insulating layer (140) comprise or consist of prepreg material.

4. The method according to any one of the claims 1 to 3,
wherein the first electrically insulating layer (130) and the second electrically insulating layer (140) are formed of a low Young modulus material with a Young modulus of less than 10 GPa.

5. The method according to the claims 1 to 4,
wherein placing the first electronic component (115) in the first cavity (111) is done after coupling the first base structure (110) with the first separation surface;
wherein placing the second electronic component (125) in the second cavity (121) is done after coupling the second base structure (120) with the second separation surface.

6. The method according to any one of the claims 1 to 4,
wherein placing the first electronic component (115) in the first cavity (111) is done before coupling the first base structure (110) with the first separation surface (151); and
wherein placing the second electronic component (125) in the second cavity (121) is done before coupling the second base structure (120) with the second separation surface (152);
the method further comprising:
attaching the first base structure (110) on the first electrically insulating layer (130) such that a main surface (117) of the first electronic component (115) is directly attached to the first electrically insulating layer (130); and
attaching the second base structure (120) on the second electrically insulating layer (140) such that a main surface (127) of the second electronic component (125) is directly attached to the second electrically insulating layer (140).

7. The method according to claim 6, further comprising:
pressing the first electronic component (115) in the first electrically insulating layer (130) so that the first electronic component (115) becomes at least partially embedded by the first electrically insulating layer (130); and/or
pressing the second electronic component (125) in the second electrically insulating layer (140) so that the second electronic component (125) becomes at least partially embedded by the second electrically insulating layer (140).

8. The method according to any one of the preceding claims, further comprising:
laminating a first further electrically insulating layer structure (108) on the first base structure (110) or the first component carrier (100a), in particular such that the first electronic component (115) is at least partially embedded with the first further electrically insulating layer structure (108); and/or
laminating a second further electrically insulating layer structure (109) on the second base structure (120) or the second component carrier (100b), in particular such that the second electronic component (125) is at least partially embedded with the second further electrically insulating layer structure (109);
forming a first electrically conductive interconnection (170), in particular a first via, more in particular through the first further electrically insulating layer structure (108), in order to electrically contact a first electric contact (116) of the first electronic component (115); and/or
forming a second electrically conductive interconnection (180), in particular a second via, more in particular through the second further electrically insulating layer structure (109), in order to electrically contact a first electric contact (126) of the second electronic component (125).

9. The method according to the preceding claim, further comprising:
forming a second electric contact (162), in particular formed as a solder ball, on a main surface (165) of the first component carrier (100a), and
electrically connecting the second electric contact (162) through the first electrically conductive interconnection (170) with the first electric contact (116) of the first electronic component (115),
wherein the second electric contact (162) is larger than the first electric contact (116) of the first electronic component (115) so that a first redistribution structure (160) is provided; and/or
forming a further second electric contact (163), in particular formed as a solder ball, on a further main surface (166) of the second component carrier (100b), and
electrically connecting the further second electric contact (163) through the second electrically conductive interconnection (180) with the second electric contact (126) of the second electronic component (125),
wherein the further second electric contact (163) is larger than the further second electric contact (126) of the second electronic component (125) so that a second redistribution structure (161) is provided.

10. The method according to the preceding claim,
wherein the first electronic component (115) is sandwiched between the first electrically insulating layer (130), in particular at least partially embedded in the first electrically insulating layer (130), and the first redistribution structure (160); and/or
wherein the second electronic component (125) is sandwiched between the second electrically insulating layer (140), in particular at least partially embedded in the second electrically insulating layer (140), and the second redistribution structure (161).

11. The method according any one of the claims 1 to 10, comprising one of the following features:
wherein separating comprises:
detaching the first component carrier (100a) including the first electrically insulating layer (130) from the separation component (150); and/or
detaching the second component carrier (100b) including the second electrically insulating layer (140) from the separation component (150);
wherein attaching the first base structure (110) on top of the first electrically insulating layer (130) further comprises:
piercing at least one first electrically conductive pillar structure (114) of the first base structure (110) into the first electrically insulating layer (130); and/or
wherein attaching the second base structure (120) on top of the second electrically insulating layer (140) further comprises:
piercing at least one second electrically conductive pillar structure (124) of the second base structure (120) into the second electrically insulating layer (140);
wherein the separation component (150) is fully surrounded by material of the first electrically insulating layer (130) and the second electrically insulating layer (140);
wherein the separation component (150) is a detachment core, in particular a core structure sandwiched between two detach copper foils;
wherein the first component carrier (100a) and/or the second component carrier (100b) is a coreless component carrier;
wherein the first electronic component (115) is placed on a first temporary carrier (190) of the first base structure (110), wherein the method further comprises:
removing the first temporary carrier (190) after coupling the first base structure (110) with the first separation surface (151); and/or wherein the second electronic component (125) is placed on a second temporary carrier (190) of the second base structure (120), wherein the method further comprises:
removing the second temporary carrier (190) after coupling the second base structure (120) with the second separation surface (152).

12. A semi-finished product (195), comprising:
a separation component (150) having a first separation surface (151) and a second separation surface (152), wherein the second separation surface (152) is opposed to the first separation surface (151);
a first component carrier (100a) comprising a first base structure (110) and a first electronic component (115) placed in a cavity (111) of the first base structure (110),
wherein the first component carrier (100a) is coupled with the first separation surface (151);
a second component carrier (100b) comprising a second base structure (120) and a second electronic component (125) placed in a cavity (121) of the second base structure (120); wherein the second component carrier (100b) is coupled with the second separation surface (152);
a first electrically insulating layer (130) formed between the first separation surface (151) and the first component carrier (100a) such that the first component carrier (100a) is attached to the first electrically insulating layer (130); and
a second electrically insulating layer (140) formed between the second separation surface (152) and the second component carrier (100b) such that the second component carrier (100b) is attached to the second electrically insulating layer (140);
**characterized in that**
the electrically insulating layers (130, 140) have a larger area size than the separation component (150) and wherein the separation component (150) is laminated at the sides (153) with the electrically insulating layers (130, 140), such that the sidewalls of the separation component (150) are covered.

13. The semi-finished product (195) according to claim 12,
wherein the first electrically insulating layer (130) and the second electrically insulating layer (140) are low Young modulus layer structures (130, 140) formed of a low Young modulus material with a Young modulus of less than 10 GPa, wherein in particular the low Young modulus layer structure (130, 140) comprises or consists of prepreg material.

14. The semi-finished product (195) according to claim 12 or 13,
wherein the first electronic component (115) is at least partially embedded in the first electrically insulating layer (130); and
wherein the second electronic component (125) is at least partially embedded in the second electrically insulating layer (140);

15. The semi-finished product (195) according to any one of the claims 12 to 14,
wherein the first component carrier (100a) comprises a first redistribution structure (160), and wherein the first electronic component (115) is sandwiched between the first electrically insulating layer (130) and the first redistribution structure (160); and
wherein the second component carrier (100b) comprises a second redistribution structure (161), and wherein the second electronic component (125) is sandwiched between the second electrically insulating layer (140) and the second redistribution structure (161).

## Patentansprüche

1. Verfahren zum Herstellen eines ersten Komponententrägers (100a) und eines zweiten Komponententrägers (100b), wobei das Verfahren umfasst:
Bereitstellen einer Trennkomponente (150), die eine erste Trennfläche (151) und eine der ersten Trennfläche (151) gegenüberliegende zweite Trennfläche (152) umfasst;
Koppeln einer ersten Basisstruktur (110), die einen ersten Hohlraum (111) aufweist, mit der ersten Trennfläche (151);
Koppeln einer zweiten Basisstruktur (120), die einen zweiten Hohlraum (121) aufweist, mit der zweiten Trennfläche (152);
Anordnen einer ersten elektronischen Komponente (115) in dem ersten Hohlraum (111);
Verbinden der ersten Basisstruktur (110) mit der ersten elektronischen Komponente (115), um den ersten Komponententräger (100a) zu bilden;
Anordnen einer zweiten elektronischen Komponente (125) in dem zweiten Hohlraum (112);
Verbinden der zweiten Basisstruktur (120) mit der zweiten elektronischen Komponente (125), um den zweiten Komponententräger (100b) zu bilden;
Trennen des ersten Komponententrägers (100a) von der ersten Trennfläche (151) der Trennkomponente (150);
Trennen des zweiten Komponententrägers (100b) von der zweiten Trennfläche (152) der Trennkomponente (150);
Bilden einer ersten elektrisch isolierenden Schicht (130) auf der ersten Trennfläche (151) vor dem Koppeln der ersten Basisstruktur (110) mit der ersten Trennfläche (151) und danach
Befestigen der ersten Basisstruktur (110) auf der ersten elektrisch isolierenden Schicht (130); und
Bilden einer zweiten elektrisch isolierenden Schicht (140) auf der zweiten Trennfläche (152) vor dem Koppeln der zweiten Basisstruktur (120) mit der zweiten Trennfläche (152) und danach
Befestigen der zweiten Basisstruktur (120) auf der zweiten elektrisch isolierenden Schicht (140);
**dadurch gekennzeichnet, dass**
die elektrisch isolierenden Schichten (130, 140) eine größere Flächengröße als die Trennkomponente (150) aufweisen und die Trennkomponente (150) an den Seiten (153) mit den elektrisch isolierenden Schichten (130, 140) laminiert ist, sodass die Seitenwände der Trennkomponente (150) abgedeckt sind.

2. Verfahren nach Anspruch 1, wobei das Verfahren ferner umfasst:
Laminieren der ersten elektrisch isolierenden Schicht (130) auf die erste Trennfläche (151); und
Laminieren der zweiten elektrisch isolierenden Schicht (140) auf die zweite Trennfläche (152).

3. Verfahren nach Anspruch 1 oder 2,
wobei die erste elektrisch isolierende Schicht (130) und die zweite elektrisch isolierende Schicht (140) Prepreg-Material umfassen oder daraus bestehen.

4. Verfahren nach einem der Ansprüche 1 bis 3,
wobei die erste elektrisch isolierende Schicht (130) und die zweite elektrisch isolierende Schicht (140) aus einem Material mit niedrigem Elastizitätsmodul mit einem Elastizitätsmodul von kleiner als 10 GPa gebildet werden.

5. Verfahren nach den Ansprüchen 1 bis 4,
wobei das Anordnen der ersten elektronischen Komponente (115) in dem ersten Hohlraum (111) nach dem Koppeln der ersten Basisstruktur (110) mit der ersten Trennfläche erfolgt;
wobei das Anordnen der zweiten elektronischen Komponente (125) in dem zweiten Hohlraum (121) nach dem Koppeln der zweiten Basisstruktur (120) mit der zweiten Trennfläche erfolgt.

6. Verfahren nach einem der Ansprüche 1 bis 4,
wobei das Anordnen der ersten elektronischen Komponente (115) in dem ersten Hohlraum (111) vor dem Koppeln der ersten Basisstruktur (110) mit der ersten Trennfläche (151) erfolgt; und
wobei das Anordnen der zweiten elektronischen Komponente (125) in dem zweiten Hohlraum (121) vor dem Koppeln der zweiten Basisstruktur (120) mit der zweiten Trennfläche (152) erfolgt; wobei das Verfahren ferner umfasst:
Befestigen der ersten Basisstruktur (110) auf der ersten elektrisch isolierenden Schicht (130), sodass eine Hauptfläche (117) der ersten elektronischen Komponente (115) direkt an der ersten elektrisch isolierenden Schicht (130) befestigt wird; und
Befestigen der zweiten Basisstruktur (120) auf der zweiten elektrisch isolierenden Schicht (140), sodass eine Hauptfläche (127) der zweiten elektronischen Komponente (125) direkt an der zweiten elektrisch isolierenden Schicht (140) befestigt wird.

7. Verfahren nach Anspruch 6, ferner umfassend:
Pressen der ersten elektronischen Komponente (115) in die erste elektrisch isolierende Schicht (130), sodass die erste elektronische Komponente (115) mindestens teilweise durch die erste elektrisch isolierende Schicht (130) eingebettet wird; und/oder
Pressen der zweiten elektronischen Komponente (125) in die zweite elektrisch isolierende Schicht (140), sodass die zweite elektronische Komponente (125) mindestens teilweise durch die zweite elektrisch isolierende Schicht (140) eingebettet wird.

8. Verfahren nach einem der vorstehenden Ansprüche, ferner umfassend:
Laminieren einer ersten weiteren elektrisch isolierenden Schichtstruktur (108) auf die erste Basisstruktur (110) oder den ersten Komponententräger (100a) insbesondere derart, dass die erste elektronische Komponente (115) mindestens teilweise in der ersten weiteren elektrisch isolierenden Schichtstruktur (108) eingebettet wird; und/oder
Laminieren einer zweiten weiteren elektrisch isolierenden Schichtstruktur (109) auf die zweite Basisstruktur (120) oder den zweiten Komponententräger (100b) insbesondere derart, dass die zweite elektronische Komponente (125) mindestens teilweise in der zweiten weiteren elektrisch isolierenden Schichtstruktur (109) eingebettet wird;
Bilden einer ersten elektrisch leitfähigen Verbindung (170), insbesondere einer ersten Durchkontaktierung, insbesondere durch die erste weitere elektrisch isolierende Schichtstruktur (108), um einen ersten elektrischen Kontakt (116) der ersten elektronischen Komponente (115) elektrisch zu kontaktieren; und/oder
Bilden einer zweiten elektrisch leitfähigen Verbindung (180), insbesondere einer zweiten Durchkontaktierung, insbesondere durch die zweite weitere elektrisch isolierende Schichtstruktur (109), um einen ersten elektrischen Kontakt (126) der zweiten elektronischen Komponente (125) elektrisch zu kontaktieren.

9. Verfahren nach dem vorstehenden Anspruch, ferner umfassend:
Bilden eines zweiten elektrischen Kontakts (162), insbesondere als Lötkugel gebildet, auf einer Hauptfläche (165) des ersten Komponententrägers (100a) und
elektrisch Verbinden des zweiten elektrischen Kontakts (162) durch die erste elektrisch leitfähige Verbindung (170) mit dem ersten elektrischen Kontakt (116) der ersten elektronischen Komponente (115),
wobei der zweite elektrische Kontakt (162) größer ist als der erste elektrische Kontakt (116) der ersten elektronischen Komponente (115), sodass eine erste Umverteilungsstruktur (160) vorgesehen wird; und/oder
Bilden eines weiteren zweiten elektrischen Kontakts (163), insbesondere als Lötkugel gebildet, auf einer weiteren Hauptfläche (166) des zweiten Komponententrägers (100b) und
elektrisch Verbinden des weiteren zweiten elektrischen Kontakts (163) durch die zweite elektrisch leitfähige Verbindung (180) mit dem zweiten elektrischen Kontakt (126) der zweiten elektronischen Komponente (125),
wobei der weitere zweite elektrische Kontakt (163) größer ist als der weitere zweite elektrische Kontakt (126) der zweiten elektronischen Komponente (125), sodass eine zweite Umverteilungsstruktur (161) vorgesehen wird.

10. Verfahren nach dem vorstehenden Anspruch,
wobei die erste elektronische Komponente (115) zwischen der ersten elektrisch isolierenden Schicht (130), insbesondere mindestens teilweise eingebettet in die erste elektrisch isolierende Schicht (130), und der ersten Umverteilungsstruktur (160) angeordnet wird; und/oder
wobei die zweite elektronische Komponente (125) zwischen der zweiten elektrisch isolierenden Schicht (140), insbesondere mindestens teilweise eingebettet in die zweite elektrisch isolierende Schicht (140), und der zweiten Umverteilungsstruktur (161) angeordnet wird.

11. Verfahren nach einem der Ansprüche 1 bis 10, umfassend eines der folgenden Merkmale:
wobei das Trennen umfasst:
Ablösen des ersten Komponententrägers (100a) einschließlich der ersten elektrisch isolierenden Schicht (130) von der Trennkomponente (150); und/oder
Ablösen des zweiten Komponententrägers (100b) einschließlich der zweiten elektrisch isolierenden Schicht (140) von der Trennkomponente (150);
wobei das Befestigen der ersten Basisstruktur (110) oben auf der ersten elektrisch isolierenden Schicht (130) ferner umfasst:
Durchbohren von mindestens einer ersten elektrisch leitfähigen Säulenstruktur (114) der ersten Basisstruktur (110) in die erste elektrisch isolierende Schicht (130); und/oder wobei das Befestigen der zweiten Basisstruktur (120) auf der Oberseite der zweiten elektrisch isolierenden Schicht (140) ferner umfasst:
Durchbohren von mindestens einer zweiten elektrisch leitenden Säulenstruktur (124) der zweiten Basisstruktur (120) in die zweite elektrisch isolierende Schicht (140);
wobei die Trennkomponente (150) vollständig von Material der ersten elektrisch isolierenden Schicht (130) und der zweiten elektrisch isolierenden Schicht (140) umgeben wird;
wobei die Trennkomponente (150) ein Ablösungskern und insbesondere eine Kernstruktur ist, die zwischen zwei Ablösekupferfolien angeordnet wird;
wobei der erste Komponententräger (100a) und/oder der zweite Komponententräger (100b) ein kernloser Komponententräger ist;
wobei die erste elektronische Komponente (115) auf einem ersten temporären Träger (190) der ersten Basisstruktur (110) angeordnet wird, wobei das Verfahren ferner umfasst:
Entfernen des ersten temporären Trägers (190) nach dem Koppeln der ersten Basisstruktur (110) mit der ersten Trennfläche (151); und/oder wobei die zweite elektronische Komponente (125) auf einem zweiten temporären Träger (190) der zweiten Basisstruktur (120) angeordnet wird, wobei das Verfahren ferner umfasst:
Entfernen des zweiten temporären Trägers (190) nach dem Koppeln der zweiten Basisstruktur (120) mit der zweiten Trennfläche (152).

12. Halbfertigprodukt (195), umfassend:
eine Trennkomponente (150) mit einer ersten Trennfläche (151) und einer zweiten Trennfläche (152), wobei die zweite Trennfläche (152) der ersten Trennfläche (151) gegenüberliegt;
einen ersten Komponententräger (100a), der eine erste Basisstruktur (110) und eine in einem Hohlraum (111) der ersten Basisstruktur (110) angeordnete erste elektronische Komponente (115) umfasst,
wobei der erste Komponententräger (100a) mit der ersten Trennfläche (151) gekoppelt ist;
einen zweiten Komponententräger (100b), der eine zweite Basisstruktur (120) und eine in einem Hohlraum (121) der zweiten Basisstruktur (120) angeordnete zweite elektronische Komponente (125) umfasst; wobei der zweite Komponententräger (100b) mit der zweiten Trennfläche (152) gekoppelt ist;
eine erste elektrisch isolierende Schicht (130), die zwischen der ersten Trennfläche (151) und dem ersten Komponententräger (100a) gebildet ist, sodass der erste Komponententräger (100a) an der ersten elektrisch isolierenden Schicht (130) befestigt ist; und
eine zweite elektrisch isolierende Schicht (140), die zwischen der zweiten Trennfläche (152) und dem zweiten Komponententräger (100b) gebildet ist, sodass der zweite Komponententräger (100b) an der zweiten elektrisch isolierenden Schicht (140) befestigt ist;
**dadurch gekennzeichnet, dass**
die elektrisch isolierenden Schichten (130, 140) eine größere Flächengröße als die Trennkomponente (150) aufweisen, und wobei die Trennkomponente (150) an den Seiten (153) mit den elektrisch isolierenden Schichten (130, 140) laminiert ist, sodass die Seitenwände der Trennkomponente (150) abgedeckt sind.

13. Halbfertigprodukt (195) nach Anspruch 12,
wobei die erste elektrisch isolierende Schicht (130) und die zweite elektrisch isolierende Schicht (140) Schichtstrukturen (130, 140) mit niedrigem Elastizitätsmodul sind, die aus einem Material mit niedrigem Elastizitätsmodul mit einem Elastizitätsmodul von kleiner als 10 GPa gebildet sind, wobei insbesondere die Schichtstruktur (130, 140) mit niedrigem Elastizitätsmodul Prepreg-Material umfasst oder daraus besteht.

14. Halbfertigprodukt (195) nach Anspruch 12 oder 13,
wobei die erste elektronische Komponente (115) mindestens teilweise in die erste elektrisch isolierende Schicht (130) eingebettet ist; und
wobei die zweite elektronische Komponente (125) mindestens teilweise in die zweite elektrisch isolierende Schicht (140) eingebettet ist;

15. Halbfertigprodukt (195) nach einem der Ansprüche 12 bis 14, wobei der erste Komponententräger (100a) eine erste Umverteilungsstruktur (160) umfasst, und wobei die erste elektronische Komponente (115) zwischen der ersten elektrisch isolierenden Schicht (130) und der ersten Umverteilungsstruktur (160) angeordnet ist; und
wobei der zweite Komponententräger (100b) eine zweite Umverteilungsstruktur (161) umfasst, und wobei die zweite elektronische Komponente (125) zwischen der zweiten elektrisch isolierenden Schicht (140) und der zweiten Umverteilungsstruktur (161) angeordnet ist.

## Revendications

1. Procédé de fabrication d'un premier support de composant (100a) et d'un deuxième support de composant (100b), le procédé comprenant :
la fourniture d'un composant de séparation (150) comprenant une première surface de séparation (151) et une deuxième surface de séparation (152) opposée à la première surface de séparation (151) ;
le couplage d'une première structure de base (110) ayant une première cavité (111) avec la première surface de séparation (151) ;
le couplage d'une deuxième structure de base (120) ayant une deuxième cavité (121) avec la deuxième surface de séparation (152) ;
le placement d'un premier composant électronique (115) dans la première cavité (111) ;
la connexion de la première structure de base (110) avec le premier composant électronique (115) pour former le premier support de composant (100a) ;
le placement d'un deuxième composant électronique (125) dans la deuxième cavité (112) ;
la connexion de la deuxième structure de base (120) avec le deuxième composant électronique (125) pour former le deuxième support de composant (100b) ;
la séparation du premier support de composant (100a) de la première surface de séparation (151) du composant de séparation (150) ;
la séparation du deuxième support de composant (100b) de la deuxième surface de séparation (152) du composant de séparation (150) ;
la formation d'une première couche électro-isolante (130) sur la première surface de séparation (151) avant le couplage de la première structure de base (110) avec la première surface de séparation (151), et ensuite,
la fixation de la première structure de base (110) sur la première couche électro-isolante (130) ; et
la formation d'une deuxième couche électro-isolante (140) sur la deuxième surface de séparation (152) avant le couplage de la deuxième structure de base (120) avec la deuxième surface de séparation (152), et ensuite,
la fixation de la deuxième structure de base (120) sur la deuxième couche électro-isolante (140) ;
**caractérisé en ce que**
les couches électro-isolantes (130, 140) ont une taille en superficie plus grande que le composant de séparation (150) et le composant de séparation (150) est stratifié au niveau des côtés (153) avec les couches électro-isolantes (130, 140), de sorte que les parois latérales du composant de séparation (150) sont recouvertes.

2. Procédé selon la revendication 1, dans lequel le procédé comprend en outre :
la stratification de la première couche électro-isolante (130) sur la première surface de séparation (151) ; et
la stratification de la deuxième couche électro-isolante (140) sur la deuxième surface de séparation (152).

3. Procédé selon la revendication 1 ou 2, dans lequel la première couche électro-isolante (130) et la deuxième couche électro-isolante (140) comprennent, ou sont constituées de, un matériau préimprégné.

4. Procédé selon l'une quelconque des revendications 1 à 3, dans lequel la première couche électro-isolante (130) et la deuxième couche électro-isolante (140) sont formées d'un matériau à faible module de Young avec un module de Young inférieur à 10 GPa.

5. Procédé selon les revendications 1 à 4, dans lequel le placement du premier composant électronique (115) dans la première cavité (111) est effectué après le couplage de la première structure de base (110) avec la première surface de séparation ;
dans lequel le placement du deuxième composant électronique (125) dans la deuxième cavité (121) est effectué après le couplage de la deuxième structure de base (120) avec la deuxième surface de séparation.

6. Procédé selon l'une quelconque des revendications 1 à 4, dans lequel le placement du premier composant électronique (115) dans la première cavité (111) est effectué avant le couplage de la première structure de base (110) avec la première surface de séparation (151) ; et
dans lequel le placement du deuxième composant électronique (125) dans la deuxième cavité (121) est effectué avant le couplage de la deuxième structure de base (120) avec la deuxième surface de séparation (152) ;
le procédé comprenant en outre :
la fixation de la première structure de base (110) sur la première couche électro-isolante (130) de telle sorte qu'une surface principale (117) du premier composant électronique (115) est directement fixée à la première couche électro-isolante (130) ; et
la fixation de la deuxième structure de base (120) sur la deuxième couche électro-isolante (140) de telle sorte qu'une surface principale (127) du deuxième composant électronique (125) est directement fixée à la deuxième couche électro-isolante (140).

7. Procédé selon la revendication 6, comprenant en outre :
le fait de presser le premier composant électronique (115) dans la première couche électro-isolante (130) de telle sorte que le premier composant électronique (115) soit au moins partiellement intégré par la première couche électro-isolante (130) ; et/ou
le fait de presser le deuxième composant électronique (125) dans la deuxième couche électro-isolante (140) de telle sorte que le deuxième composant électronique (125) soit au moins partiellement intégré par la deuxième couche électro-isolante (140).

8. Procédé selon l'une quelconque des revendications précédentes, comprenant en outre :
la stratification d'une première autre structure de couche électro-isolante (108) sur la première structure de base (110) ou sur le premier support de composant (100a), en particulier de telle sorte que le premier composant électronique (115) est au moins partiellement intégré dans la première autre structure de couche électro-isolante (108) ; et/ou
la stratification d'une deuxième autre structure de couche électro-isolante (109) sur la deuxième structure de base (120) ou sur le deuxième support de composant (100b), en particulier de telle sorte que le deuxième composant électronique (125) est au moins partiellement intégré dans l'autre deuxième structure de couche électro-isolante (109) ;
la formation d'une première interconnexion électroconductrice (170), en particulier un premier trou d'interconnexion, plus particulièrement à travers la première autre structure de couche électro-isolante (108), afin de mettre électriquement en contact un premier contact électrique (116) du premier composant électronique (115) ; et/ou
la formation d'une deuxième interconnexion électroconductrice (180), en particulier un deuxième trou d'interconnexion, plus particulièrement à travers la deuxième autre structure de couche électro-isolante (109), afin de mettre électriquement en un premier contact électrique (126) du deuxième composant électronique (125).

9. Procédé selon la revendication précédente, comprenant en outre : la formation d'un deuxième contact électrique (162), en particulier sous la forme d'une perle de soudure, sur une surface principale (165) du premier support de composant (100a), et
la connexion électrique du deuxième contact électrique (162) par l'intermédiaire de la première interconnexion électroconductrice (170) avec le premier contact électrique (116) du premier composant électronique (115),
dans lequel le deuxième contact électrique (162) est plus grand que le premier contact électrique (116) du premier composant électronique (115) de sorte qu'une première structure de redistribution (160) est fournie ; et/ou
la formation d'un autre deuxième contact électrique (163), en particulier sous la forme d'une perle de soudure, sur une autre surface principale (166) du deuxième support de composant (100b), et
la connexion électrique de l'autre deuxième contact électrique (163) par l'intermédiaire de la deuxième interconnexion électroconductrice (180) avec le deuxième contact électrique (126) du deuxième composant électronique (125), dans lequel l'autre deuxième contact électrique (163) est plus grand que l'autre deuxième contact électrique (126) du deuxième composant électronique (125) de sorte qu'une deuxième structure de redistribution (161) est fournie.

10. Procédé selon la revendication précédente, dans lequel le premier composant électronique (115) est intercalé entre la première couche électro-isolante (130), en particulier au moins partiellement intégré dans la première couche électro-isolante (130), et la première structure de redistribution (160) ; et/ou
dans lequel le deuxième composant électronique (125) est intercalé entre la deuxième couche électro-isolante (140), en particulier au moins partiellement intégrée dans la deuxième couche électro-isolante (140), et la deuxième structure de redistribution (161).

11. Procédé selon l'une quelconque des revendications 1 à 10, comprenant au moins l'une des caractéristiques suivantes :
dans lequel la séparation comprend :
le détachement du premier support de composant (100a) comprenant la première couche électro-isolante (130) du composant de séparation (150) ; et/ou
le détachement du deuxième support de composant (100b) comportant la deuxième couche électro-isolante (140) du composant de séparation (150) ;
dans lequel la fixation de la première structure de base (110) sur le dessus de la première couche électro-isolante (130) comprend en outre :
le perçage d'au moins une première structure de pilier électroconductrice (114) de la première structure de base (110) dans la première couche électro-isolante (130) ; et/ou
dans lequel la fixation de la deuxième structure de base (120) sur le dessus de la deuxième couche électro-isolante (140) comprend en outre :
le perçage d'au moins une deuxième structure de pilier électroconductrice (124) de la deuxième structure de base (120) dans la deuxième couche électro-isolante (140) ;
dans lequel le composant de séparation (150) est complètement entouré par le matériau de la première couche électro-isolante (130) et de la deuxième couche électro-isolante (140) ;
dans lequel le composant de séparation (150) est un noyau de détachement, en particulier une structure de noyau intercalée entre deux papiers de cuivre de détachement ;
dans lequel le premier support de composant (100a) et/ou le deuxième support de composant (100b) est un support de composant sans noyau ;
dans lequel le premier composant électronique (115) est placé sur un premier support temporaire (190) de la première structure de base (110), dans lequel le procédé comprend en outre :
le retrait du premier support temporaire (190) après le couplage de la première structure de base (110) avec la première surface de séparation (151) ; et/ou dans lequel le deuxième composant électronique (125) est placé sur un deuxième support temporaire (190) de la deuxième structure de base (120), dans lequel le procédé comprend en outre :
le retrait du deuxième support temporaire (190) après le couplage de la deuxième structure de base (120) avec la deuxième surface de séparation (152).

12. Produit semi-fini (195), comprenant :
un composant de séparation (150) ayant une première surface de séparation (151) et une deuxième surface de séparation (152), dans lequel la deuxième surface de séparation (152) est opposée à la première surface de séparation (151) ;
un premier support de composant (100a) comprenant une première structure de base (110) et un premier composant électronique (115) placé dans une cavité (111) de la première structure de base (110), dans lequel le premier support de composant (100a) est couplé à la première surface de séparation (151) ;
un deuxième support de composant (100b) comprenant une deuxième structure de base (120) et un deuxième composant électronique (125) placé dans une cavité (121) de la deuxième structure de base (120) ; dans lequel le deuxième support de composant (100b) est couplé à la deuxième surface de séparation (152) ;
une première couche électro-isolante (130) formée entre la première surface de séparation (151) et le premier support de composant (100a) de telle sorte que le premier support de composant (100a) est fixé à la première couche électro-isolante (130) ; et
une deuxième couche électro-isolante (140) formée entre la deuxième surface de séparation (152) et le deuxième support de composant (100b) de telle sorte que
le deuxième support de composant (100b) est fixé à la deuxième couche électro-isolante (140) ;
**caractérisé en ce que**
les couches électro-isolantes (130, 140) ont une taille en superficie plus grande que le composant de séparation (150) et dans lequel le composant de séparation (150) est stratifié au niveau des côtés (153) avec les couches électro-isolantes (130, 140), de sorte que les parois latérales du composant de séparation (150) sont recouvertes.

13. Produit semi-fini (195) selon la revendication 12, dans lequel la première couche électro-isolante (130) et la deuxième couche électro-isolante (140) sont des structures de couche à faible module de Young (130, 140) formées d'un matériau à faible module de Young avec un module de Young inférieur à 10 GPa, dans lequel en particulier la structure de couche à faible module de Young (130, 140) comprend, ou est constituée de, un matériau préimprégné.

14. Produit semi-fini (195) selon la revendication 12 ou 13, dans lequel le premier composant électronique (115) est au moins partiellement intégré dans la première couche électro-isolante (130) ; et
dans lequel le deuxième composant électronique (125) est au moins partiellement intégré dans la deuxième couche électro-isolante (140) ;

15. Produit semi-fini (195) selon l'une quelconque des revendications 12 à 14, dans lequel le premier support de composant (100a) comprend une première structure de redistribution (160), dans lequel le premier composant électronique (115) est intercalé entre la première couche électro-isolante (130) et la première structure de redistribution (160) ; et dans lequel le deuxième support de composant (100b) comprend une deuxième structure de redistribution (161), et dans lequel le deuxième composant électronique (125) est intercalé entre la deuxième couche électro-isolante (140) et la deuxième structure de redistribution (161).
